# EUROPEAN PATENT APPLICATION

(11) **EP 4 651 663 A2**
(43) Date of publication of application: **19.11.2025**
(21) Application number: 25174402.5
(22) Date of filing: 06.05.2025
(51) Int. Cl.: H10B 10/00, H10D 84/01, H01L 23/528, H10D 89/10, H10D 62/00

(54) **INTEGRATED CIRCUIT INCLUDING BIT CELL**

(30) Priority: 14.05.2024 KR 20240063398; 25.09.2024 KR 20240130211
(71) Applicant: Samsung Electronics Co., Ltd., Suwon-si, Gyeonggi-do 16677 (KR)
(72) Inventor: KIM, Taehyung, 16677 Suwon-si (KR); PARK, Jimin, 16677 Suwon-si (KR); CHOI, Seung, 16677 Suwon-si (KR); TANG, Hoyoung, 16677 Suwon-si (KR); LIM, Jaehyun, 16677 Suwon-si (KR)
(74) Representative: Marks & Clerk LLP

(57) **Abstract**

Provided is an integrated circuit. The integrated circuit includes a bit cell array including a plurality of bit cells and a periphery circuit apart from the bit cell array in a first direction. Each bit cell of the plurality of bit cells includes first active patterns and a first gate line surrounding the first active patterns. The periphery circuit includes second active patterns and a second gate line surrounding the second active patterns. The first and second active patterns each extend in the first direction, the first and second gate lines each extend in a second direction intersecting the first direction, and the first active patterns are connected to the second active patterns in a transition region between the bit cell array and the periphery circuit.

## Description

### BACKGROUND

One or more example embodiments of the disclosure relate to an integrated circuit, and more particularly, to an integrated circuit including bit cells.

Integrated circuits may include a memory including a plurality of bit cells, for example, a static random access memory (SRAM). Recently, a memory capacity has increased due to addition of functions to mobile chips, and an area occupied by a memory, such as SRAM, has also increased due to addition of a neural processing unit (NPU) for artificial intelligence (AI) inference acceleration. Thus, because the area of the memory may occupy a significant portion of a total area of an integrated circuit, a reduction in the area of the memory is required for miniaturization of the integrated circuit.

### SUMMARY

One or more example embodiments of the disclosure provide an integrated circuit that may be implemented with a reduced area by improving an area efficiency of a bit cell array and a periphery circuit.

According to an aspect of an example embodiment of the disclosure, there is provided an integrated circuit including: a bit cell array including a plurality of bit cells, each bit cell of the plurality of bit cells including a plurality of first active patterns and a first gate line surrounding the plurality of first active patterns; and a periphery circuit apart from the bit cell array in a first direction, the periphery circuit including a plurality of second active patterns and a second gate line surrounding the plurality of second active patterns, wherein each of the plurality of first active patterns and the plurality of second active patterns extends in the first direction, wherein each of the first gate lie and the second gate line extends in a second direction intersecting the first direction, and wherein the plurality of first active patterns are connected to the plurality of second active patterns in a transition region between the bit cell array and the periphery circuit.

The integrated circuit may further include a first gate insulating film between the plurality of first active patterns and the first gate line, and a second gate insulating film between the plurality of second active patterns and the second gate line.

According to an aspect of an example embodiment of the disclosure, there is provided an integrated circuit including: a bit cell array including a plurality of bit cells including a first bit cell, the first bit cell including a first gate all around (GAA) transistor, and a plurality of bit lines extending in a first direction; and an input/output circuit connected to the bit cell array through the plurality of bit lines, the input/output circuit including a plurality of standard cells, including a first standard cell, and the first standard cell including a second GAA transistor, wherein the first GAA transistor includes a first active pattern extending in the first direction, wherein the second GAA transistor includes a second active pattern extending in the first direction and connected to the first active pattern, and wherein a height of the first bit cell in a second direction intersecting the first direction is different from a height of the first standard cell in the second direction.

The bit cell array may further include a second bit cell located adjacent to the first bit cell in the second direction, the input/output circuit may further include a second standard cell and a third standard cell arranged adjacent to the first standard cell in the second direction, and a sum of heights of the first bit cell and the second bit cell in the second direction may correspond to a sum of heights of the first to the third standard cells in the second direction.

The first GAA transistor may further include a third active pattern apart from the first active pattern in the second direction, and the first active pattern and the third active pattern may be connected to the second active pattern through a merged pattern. The first active pattern may have a first width in the second direction, wherein the second active pattern has a second width in the second direction, the third active pattern may have a third width in the second direction, and the second width may be greater than the first width and the third width. The merged pattern may have a fourth width in the second direction, and the fourth width may be greater than a sum of the first width and the third width.

The first active pattern and the second active pattern may include a plurality of nanosheets or a plurality of nanowires.

According to an aspect of an example embodiment of the disclosure, there is provided an integrated circuit including: a bit cell array including a plurality of first active patterns each extending in a first direction and a first gate line extending in a second direction intersecting the first direction and surrounding the plurality of first active patterns and a periphery circuit including a second active pattern extending in the first direction and a second gate line extending in the second direction and surrounding the second active pattern, wherein the plurality of first active patterns are connected to the second active pattern through a merged pattern between the bit cell array and the periphery circuit.

At least some of the above and other features of the invention are set out in the claims.

### BRIEF DESCRIPTION OF DRAWINGS

Example embodiments will be more clearly understood from the following detailed description taken in conjunction with the accompanying drawings in which:
FIG. 1 is a block diagram illustrating a memory device included in an integrated circuit according to one or more example embodiments;
FIG. 2 is a circuit diagram illustrating a bit cell array according to one or more example embodiments;
FIG. 3 is a plan view illustrating a memory device according to one or more example embodiments;
FIG. 4 is a plan view illustrating a memory device according to one or more example embodiments;
FIG. 5 illustrates a layout of an integrated circuit according to a comparative example;
FIG. 6 illustrates a layout of an integrated circuit according to one or more example embodiments;
FIGS. 7A and 7B illustrate devices according to one or more example embodiments;
FIG. 8 illustrates active patterns arranged in a transition region according to one or more example embodiments.
FIG. 9 is a cross-sectional view taken along line I-I' of FIG. 6 according to one or more example embodiments;
FIG. 10A is a cross-sectional view taken along line II-II' of FIG. 6 according to one or more example embodiments, and FIG. 10B is a cross-sectional view taken along line III-III' of FIG. 6 according to one or more example embodiments;
FIG. 11A is a cross-sectional view taken along line II-II' of FIG. 6 according to one or more example embodiments, and FIG. 11B is a cross-sectional view taken along line III-III' of FIG. 6 according to one or more example embodiments;
FIG. 12 illustrates a layout of an integrated circuit according to one or more example embodiments;
FIG. 13 illustrates a layout of an integrated circuit according to one or more example embodiments;
FIG. 14 illustrates a layout of an integrated circuit according to one or more example embodiments.
FIG. 15 illustrates active patterns arranged in a transition region according to one or more example embodiments;
FIG. 16 illustrates a layout of an integrated circuit according to one or more example embodiments;
FIG. 17 illustrates active patterns arranged in a transition region according to one or more example embodiments;
FIG. 18 is a flowchart illustrating a method for manufacturing an integrated circuit, according to one or more example embodiments;
FIG. 19 is a block diagram illustrating a system-on-chip according to one or more example embodiments; and
FIG. 20 is a block diagram illustrating a computing system including a memory storing a program according to one or more example embodiments.

### DETAILED DESCRIPTION

Hereinafter, example embodiments are described in detail with reference to the accompanying drawings. Like reference numerals are used for like components in the drawings, and redundant descriptions thereof are omitted.

It will be understood that, although the terms first, second, third, fourth, etc. may be used herein to describe various elements, components, regions, layers and/or sections (collectively "elements"), these elements should not be limited by these terms. These terms are only used to distinguish one element from another element. Thus, a first element described in this description section may be termed a second element or vice versa in the claim section without departing from the teachings of the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

Herein, an X-axis direction may be referred to as a first direction (or first direction X), a Y-axis direction may be referred to as a second direction (or second direction Y), and a Z-axis direction may be referred to as a vertical direction (or vertical direction Z). A plane defined by an X-axis and a Y-axis may be referred to as a horizontal plane, a component positioned in a +Z-axis direction relative to other components may be referred to as being above other components, and a component positioned in a -Z-axis direction relative to other components may be referred to as being below other components. The horizontal plane may be defined parallel to an upper surface of a substrate. The vertical direction may be defined perpendicular to the upper surface of the substrate. It will be appreciated that these directions are defined relative to the structured of the device, and need not limit the orientation of the device in use.

An integrated circuit may be designed by arranging a plurality of standard cells. A standard cell may be a unit of layout of an integrated circuit and may be referred to as a "cell" depending on an embodiment. A standard cell may be designed to include a plurality of transistors to perform a predefined function. A standard cell method may be a method of preparing standard cells with various functions in advance and designing a dedicated large-scale integrated circuit that meets the specifications of customers or users by combining the standard cells. Standard cells may be designed and verified in advance and registered in a standard cell library, and integrated circuits may be designed by performing logic design, placement, and routing by combining standard cells using computer-aided design (CAD).

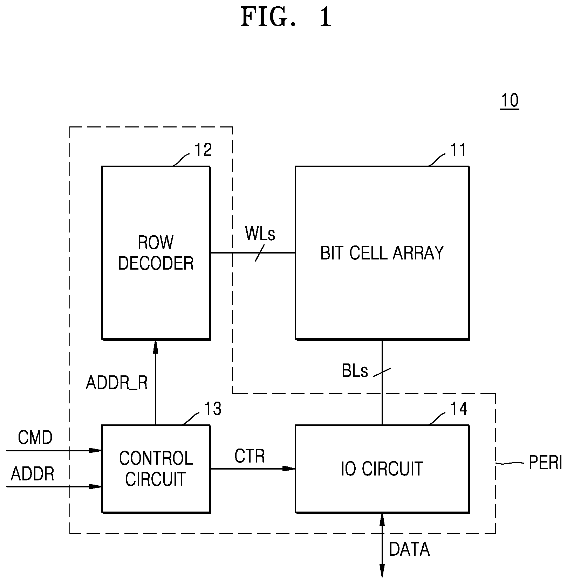

FIG. 1 is a block diagram illustrating a memory device 10 included in an integrated circuit according to one or more example embodiments.

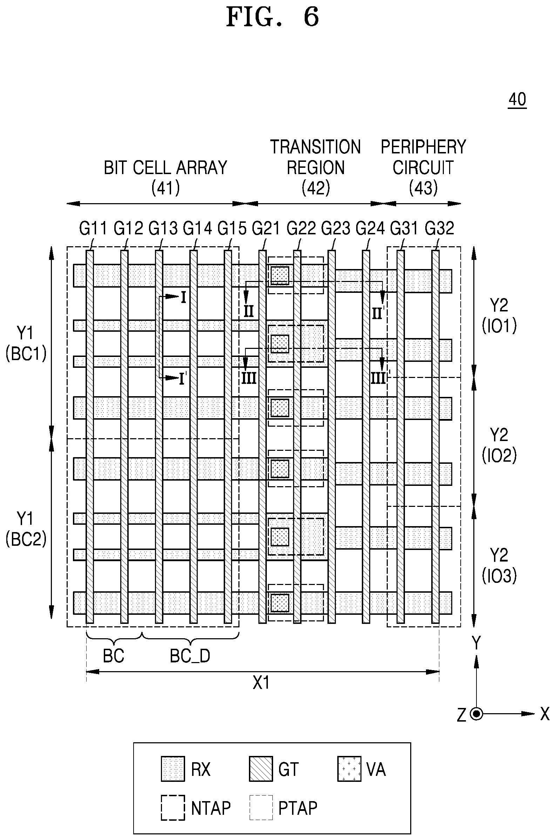

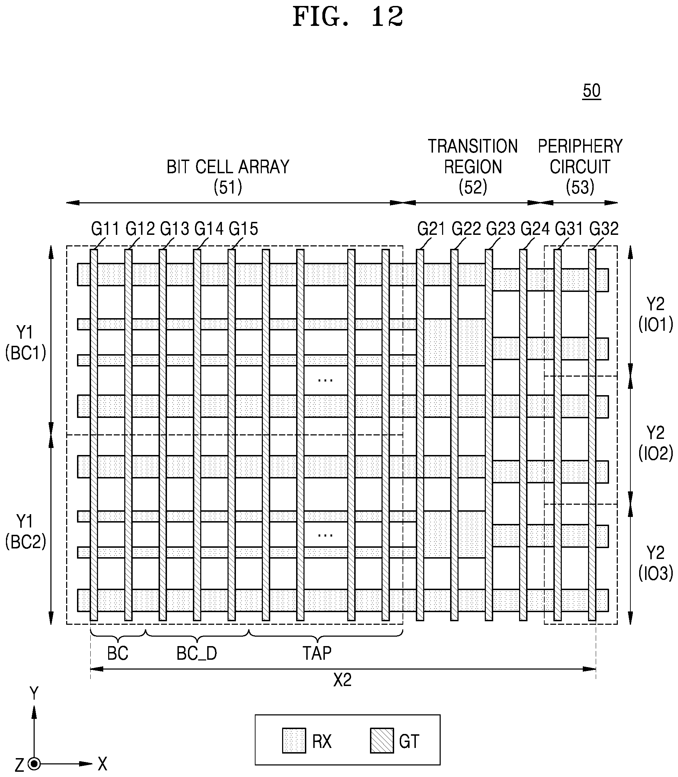

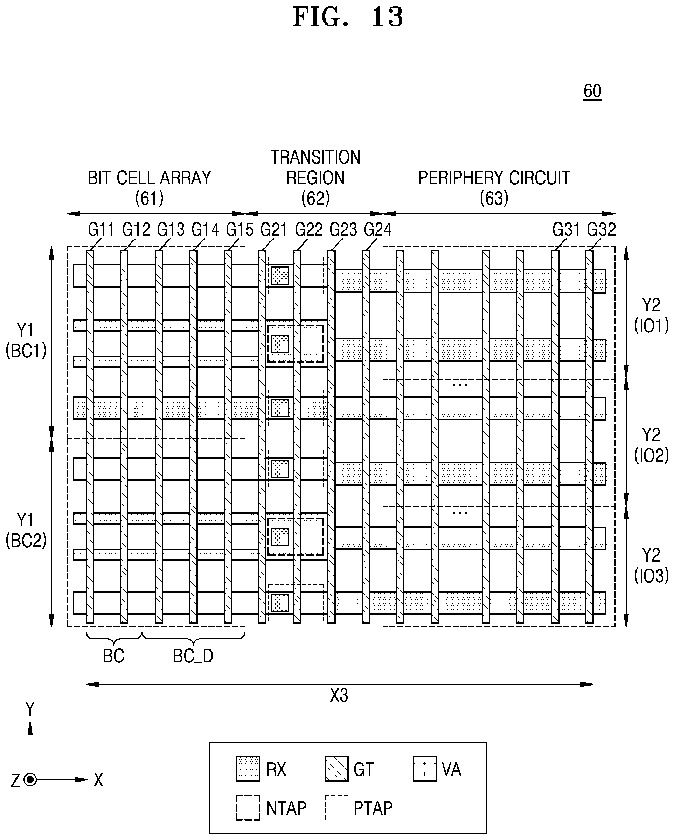

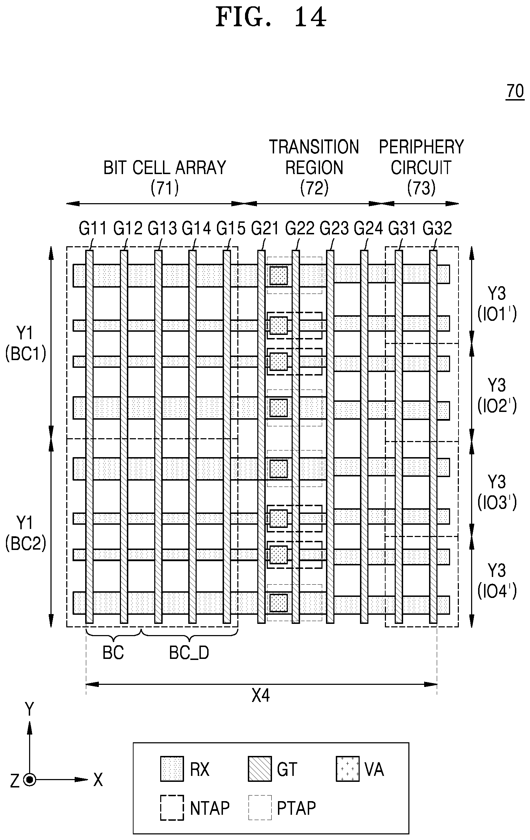

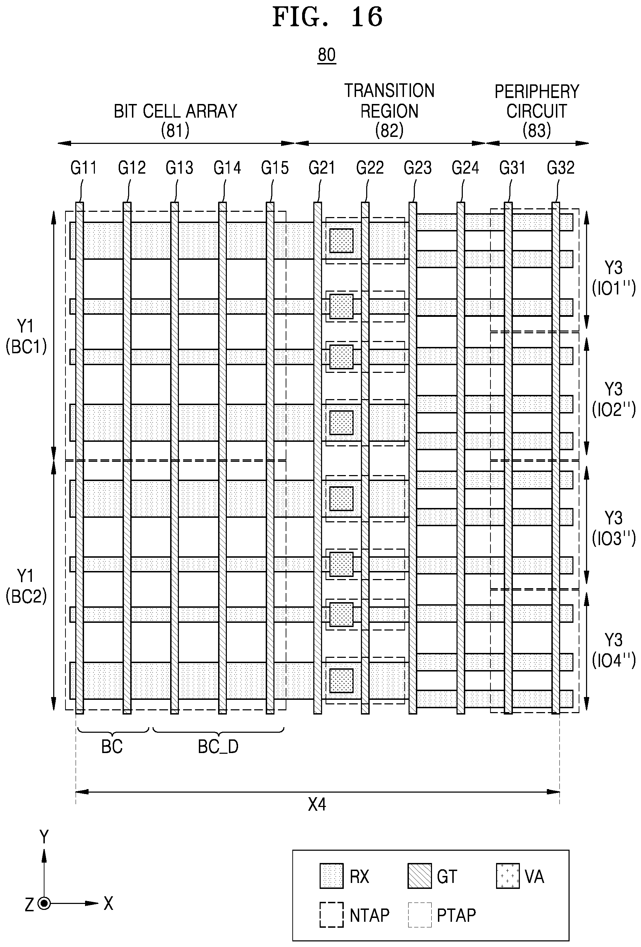

Referring to FIG. 1, the memory device 10 may include a bit cell array 11, a row decoder 12, a control circuit 13, and an input/output (I/O) circuit 14. The row decoder 12, the control circuit 13, and the I/O circuit 14 may be collectively referred to as a periphery circuit PERI. According to an embodiment, the periphery circuit PERI may further include a command buffer, an address buffer, and/or a voltage generator. For example, a partial area of the memory device 10 may be implemented as an integrated circuit 40 of FIG. 6, an integrated circuit 50 of FIG. 12, an integrated circuit 60 of FIG. 13, an integrated circuit 70 of FIG. 14, or an integrated circuit 80 of FIG. 16.

The memory device 10 may receive a command CMD, an address ADDR, and data DATA. For example, the memory device 10 may receive a command CMD for instructing writing, an address ADDR, and data DATA and accordingly, may store the received data DATA in an area of the bit cell array 11 corresponding to the address ADDR. In addition, the memory device 10 may receive a command CMD for instructing reading and an address ADDR, and accordingly, may output, to an outside, data DATA stored in an area of the bit cell array 11 corresponding to the address ADDR.

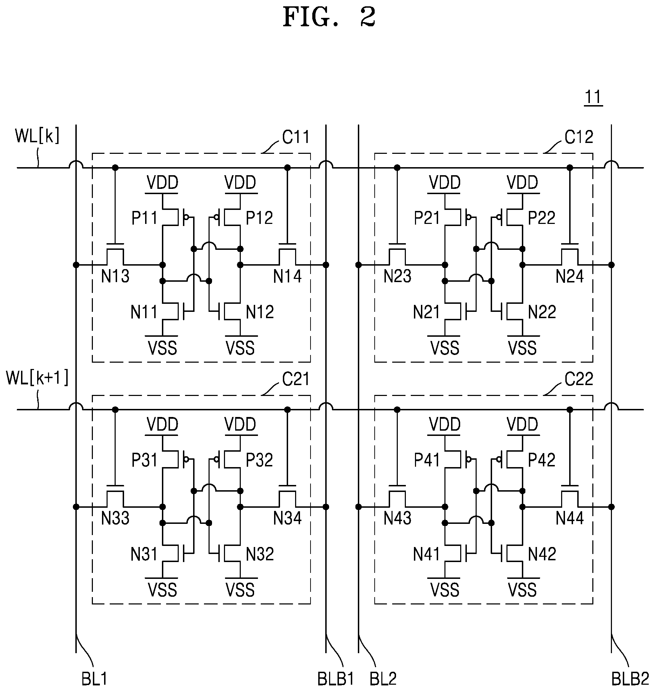

The bit cell array 11 may include a plurality of bit cells or memory cells accessed by a plurality of word lines WLs and a plurality of bit lines BLs. In some embodiments, the plurality of bit cells included in the bit cell array 11 may be volatile memory cells, such as memory cells of a static random access memory (SRAM), a dynamic random access memory (DRAM), etc. In some embodiments, the memory cells included in the bit cell array 11 may be nonvolatile memory cells, such as memory cells of a flash memory, a resistive random access memory (RRAM), etc. Embodiments are described below with reference primarily to an SRAM, as described later with reference to FIG. 2, but embodiments are not limited thereto. In some embodiments, the bit cell array 11 may include a plurality of bit lines BLs extending in a second direction Y.

The control circuit 13 may generate a row address ADDR_R and a control signal CTR, based on the command CMD and the address ADDR. For example, the control circuit 13 may identify a read command by decoding the command CMD and generate the row address ADDR_R and the control signal CTR to read data DATA from the bit cell array 11. In addition, the control circuit 13 may identify a write command by decoding the command CMD and generate the row address ADDR_R and the control signal CTR to write data DATA to the bit cell array 11.

The row decoder 12 may be connected to the bit cell array 11 through the word lines WLs and may activate one of the word lines WLs according to the row address ADDR_R. Accordingly, bit cells connected to the activated word line among the bit cells included in the bit cell array 11 may be selected. For example, the row decoder 12 may include a row driver.

The I/O circuit 14 may be connected to the bit cell array 11 through the bit lines BLs and may perform a read operation or a write operation according to the control signal CTR. For example, the I/O circuit 14 may include a column driver. The column driver may detect current and/or voltage of the bit lines BLs or apply current and/or voltage to the bit lines BLs at a timing determined based on the control signal CTR.

In an embodiment, the I/O circuit 14 may include a plurality of logic cells or a plurality of standard cells. According to an embodiment, the standard cells may be referred to as a plurality of I/O slices. For example, the standard cells may be respectively connected to the bit cells via the bit lines BLs. For example, the standard cells may include write/read circuits. For example, the standard cells may include sense amplifiers. For example, the standard cells may include column drivers or write drivers.

In a manufacturing process of the memory device 10, dummy patterns may be provided to ensure pattern uniformity. Dummy patterns may be provided in an outer region of the bit cell array 11 and an outer region of the periphery circuit PERI, and the area of the memory device 10 may increase due to the dummy patterns. For example, the bit cell array 11 and the periphery circuit PERI may include a plurality of transistors. A gate line plays an important role in a performance of a transistor, and dummy patterns having the same pitch as that of the gate line, e.g., dummy gate lines, may be arranged around the gate line. In this manner, when the dummy gate lines are provided in the bit cell array 11 and also dummy gate lines are provided in the periphery circuit PERI, the area of the memory device 10 may further increase.

According to an embodiment, the bit cell array 11 may include a plurality of first active patterns each extending in the first direction, the periphery circuit PERI includes a plurality of second active patterns each extending in the first direction, and the plurality of first active patterns may be connected to the plurality of second active patterns in a transition region (e.g., 42 in FIG. 6) between the bit cell array 11 and the periphery circuit PERI. For example, the periphery circuit PERI may include the I/O circuit 14 connected to the bit cell array 11 via the bit lines BLs. In an embodiment, the bit cell array 11 may not include dummy gate lines in an outer region, e.g., a region adjacent to the transition region. In an embodiment, the I/O circuit 14 may not include dummy gate lines in an outer region, e.g., a region adjacent to the transition region. Accordingly, the area of the memory device 10 may be reduced.

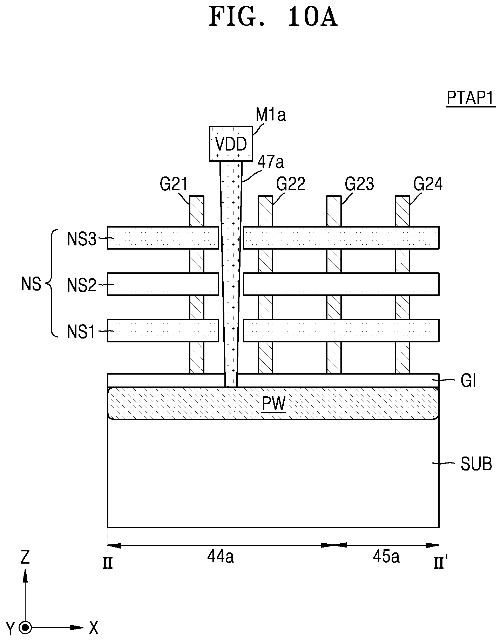

According to an embodiment, a plurality of tap cells may be arranged in the transition region in the second direction. For example, the tap cells may include a P-type tap cell configured to apply a first supply voltage to a P-type well or a P-type substrate and/or an N-type tap cell configured to apply a second supply voltage to an N-type well. Details thereof will be described later with reference to FIGS. 10A to 11B. In this manner, by utilizing the transition region between the bit cell array 11 and the I/O circuit 14 as a tap cell region, the area efficiency of the memory device 10 may be improved, thereby further reducing the area of the memory device 10.

In an embodiment, a first active pattern among the plurality of first active patterns included in the bit cell array 11 may be connected to a second active pattern among the plurality of second active patterns included in the I/O circuit 14, and the first and second active patterns may or may not be aligned with each other. The term "aligned" is used in the specification to refer to a case in which the first and second active patterns overlap with each other in the second direction, and the first and second active patterns may not be aligned with each other when there is at least a portion thereof does not overlap in the second direction. For example, the first active pattern may have a first width in the second direction, the second active pattern may have a second width in the second direction, and the first width may be equal to the second width. For example, the first active pattern may have a first width, the second active pattern may have a second width, and the first width may be different from the second width. Details thereof will be described later with reference to FIGS. 6 to 15.

In an embodiment, the plurality of first active patterns included in the bit cell array 11 may include first patterns and second patterns, and the first and second patterns included in the bit cell array 11 may be connected to a third pattern through a merged pattern located in the transition region, the third pattern being one of the plurality of second active patterns included in the I/O circuit 14. For example, the first pattern may have a first width in the second direction, the second pattern may have a second width in the second direction, the third pattern may have a third width in the second direction, and the third width may be greater than the first width and the second width. For example, the merged pattern may have a fourth width, and the fourth width may be greater than a sum of the first and second widths. Details thereof will be described later with reference to FIGS. 6 to 13.

In an embodiment, the first active pattern among the plurality of first active patterns included in the bit cell array 11 may be connected to the second active pattern among the plurality of second active patterns included in the I/O circuit 14, and the first active pattern may be aligned with the second active pattern. For example, the first active pattern may have a first width, the second active pattern may have a second width, and the first width may be equal to the second width. Details thereof will be described later with reference to FIGS. 6 to 15.

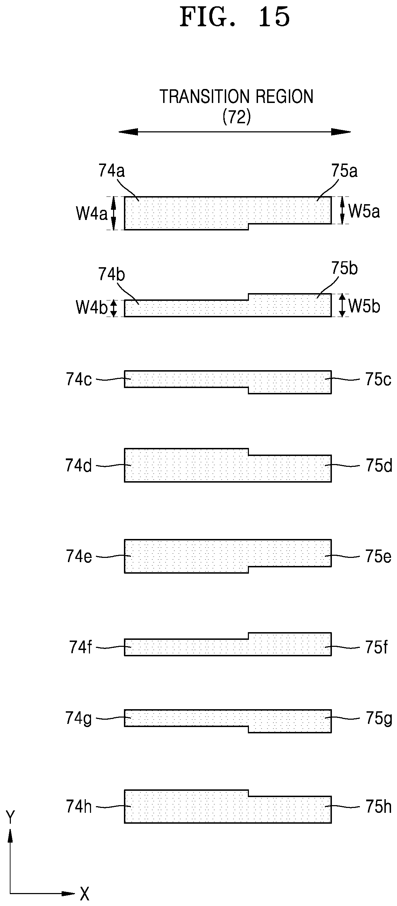

In an embodiment, a number of the plurality of first active patterns included in the bit cell array 11 may be different from a number of the plurality of second active patterns included in the I/O circuit 14. Details thereof will be described later with reference to FIGS. 6 to 13. In an embodiment, the number of the plurality of first active patterns included in the bit cell array 11 may be equal to the number of the plurality of second active patterns included in the I/O circuit 14. Details thereof will be described later with reference to FIGS. 14 and 15.

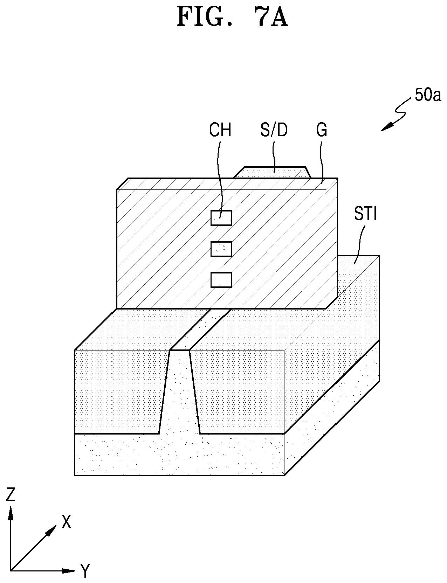

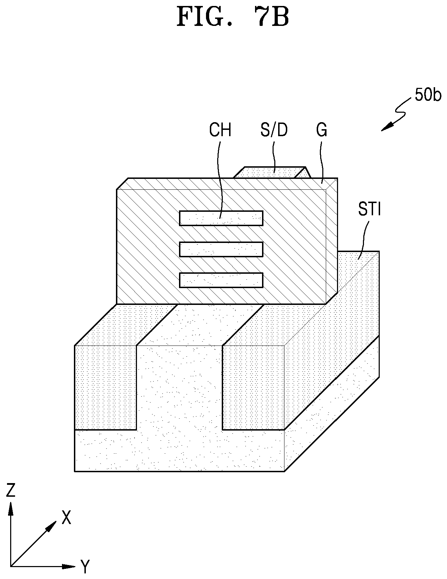

In an embodiment, the plurality of first active patterns included in the bit cell array 11 may include a plurality of nanosheets or a plurality of nanowires. In this manner, the bit cell array 11 may include gate all around (GAA) transistors. In an embodiment, the plurality of second active patterns included in the I/O circuit 14 may include a plurality of nanosheets or a plurality of nanowires. In this manner, the I/O circuit 14 may include GAA transistors. Details thereof will be described later with reference to FIGS. 7A and 7B.

FIG. 2 is a circuit diagram illustrating the bit cell array 11 according to one or more example embodiments.

Referring to FIG. 2, the bit cell array 11 may include bit cells C11, C12, C21, and C22 arranged adjacent to each other. For example, the bit cell array 11 may correspond to an example of the bit cell array 11 of FIG. 1. The bit cell C11 and the bit cell C12 arranged in the same row may be commonly connected to a word line WL[k] (k is an integer greater than 0), and the bit cell C21 and the bit cell C22 arranged in the same row may be commonly connected to a word line WL[k+1]. In addition, the bit cell C11 and the bit cell C21 arranged in the same column may be connected to a first bit line BL1 and a first complementary bit line BLB1, and the bit cell C12 and the bit cell C22 arranged in the same column may be connected to a second bit line BL2 and a second complementary bit line BLB2.

The bit cell C11 may include P channel field effect transistors (PFETs) P11 and P12 and N channel field effect transistors (NFETs) N11 to N14 and may be a 6T (six transistors) SRAM cell. The bit cell C11 may include a pair of inverters cross-coupled between a node to which a positive supply voltage (or a cell voltage) VDD is applied and a node to which a negative supply voltage (or a ground voltage) VSS is applied. For example, a first inverter of the pair of cross-coupled inverters may include the PFET P11 and the NFET N11, and a second inverter may include the PFET P12 and the NFET N12. In addition, the NFETs N13 and N14 may be referred to as transfer transistors configured to connect the first inverter and the second inverter to the first bit line BL1 and the first complementary bit line BLB1, respectively, by the activated word line WL[k] (e.g., having a high-level voltage). As illustrated in FIG. 2, each of the bit cells C12, C21, and C22 may have the same structure corresponding to the bit cell C11, and thus, the description of bit cell C11 may be applied to the bit cells C12, C21, and C22.

The bit cell C12 may include PFETs P21 and P22 and NFETs N21 to N24. The NFETs N23 and N24 may be configured to connect a first inverter, including the PFET P21 and the NFET N21, and a second inverter, including the PFET P22 and the NFET N22, to the second bit line BL2 and the second complementary bit line BLB2, respectively, by the activated word line WL[k]. The bit cell C21 may include PFETs P31 and P32 and NFETs N31 to N34. The NFETs N33 and N34 may be configured to connect a first inverter, including a PFET P31 and an NFET N31, and a second inverter, including a PFET P32 and an NFET N32, to the first bit line BL1 and the first complementary bit line BLB1, respectively, by an activated word line WL[k+1]. The bit cell C22 may include PFETs P41 and P42 and NFETs N41 to N44. The NFETs N43 and N44 may be configured to connect a first inverter, including a PFET P41 and an NFET N41, and a second inverter, including a PFET P42 and an NFET N42, to the second bit line BL2 and the second complementary bit line BLB2, respectively, by the activated word line WL[k+1].

In an embodiment, each of the bit cells C11 to C22 may include at least one GAA transistor. For example, each of the PFETs P11 to P42 and the NFETs N11 to N44 may be implemented as a GAA transistor. The GAA transistor may include an active pattern extending in the first direction (e.g., X-axis direction in FIG. 7A) and a gate line extending in the second direction (e.g., Y-axis direction in FIG. 7A). The gate line may surround the active pattern, and a gate insulating film may be located between the gate line and the active pattern. The GAA transistor will be described later with reference to FIGS. 7A and 7B.

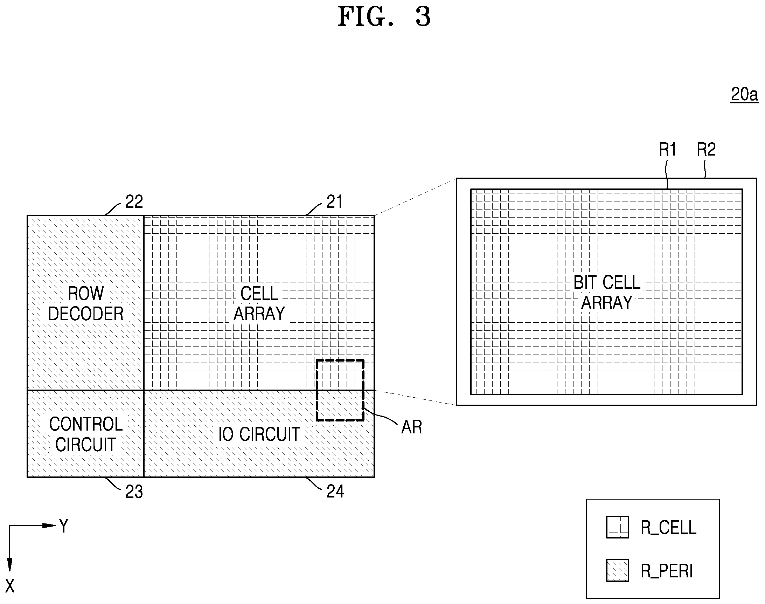

FIG. 3 is a plan view illustrating an integrated circuit 20a according to one or more example embodiments.

Referring to FIG. 3, the integrated circuit 20a may include at least one cell array arranged in a cell region R_CELL and a periphery circuit arranged in a peripheral region R_PERI. For example, the integrated circuit 20a may represent an example of a layout of an integrated circuit corresponding to the memory device 10 of FIG. 1. For example, a cell array 21 may be provided in the cell region R_CELL, and a row decoder 22, a control circuit 23, and an I/O circuit 24 may be provided in the peripheral region R_PERI. According to an embodiment, the row decoder 22 may be referred to as a row driver, and the I/O circuit 24 may be referred to as a column driver.

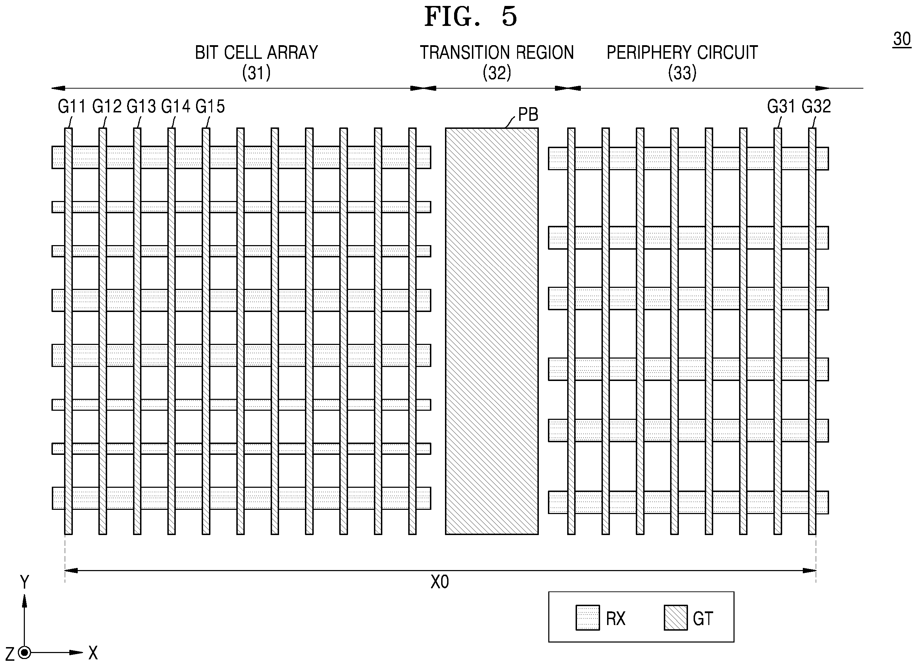

The cell region R_CELL may include a cell array region R1 and a transition region R2. A bit cell array including a plurality of bit cells may be located in the cell array region R1. The transition region R2 may surround the cell array region R1 and may also be referred to as a dummy region, an outer region, or a termination region. The I/O circuit 24 may be provided adjacent to the cell array 21 in the first direction X. The row decoder 22 may be provided adjacent to the cell array 21 in the second direction Y. Hereinafter, a partial region AR of the cell array 21 and the I/O circuit 24 is described in detail with reference to FIGS. 5 to 14.

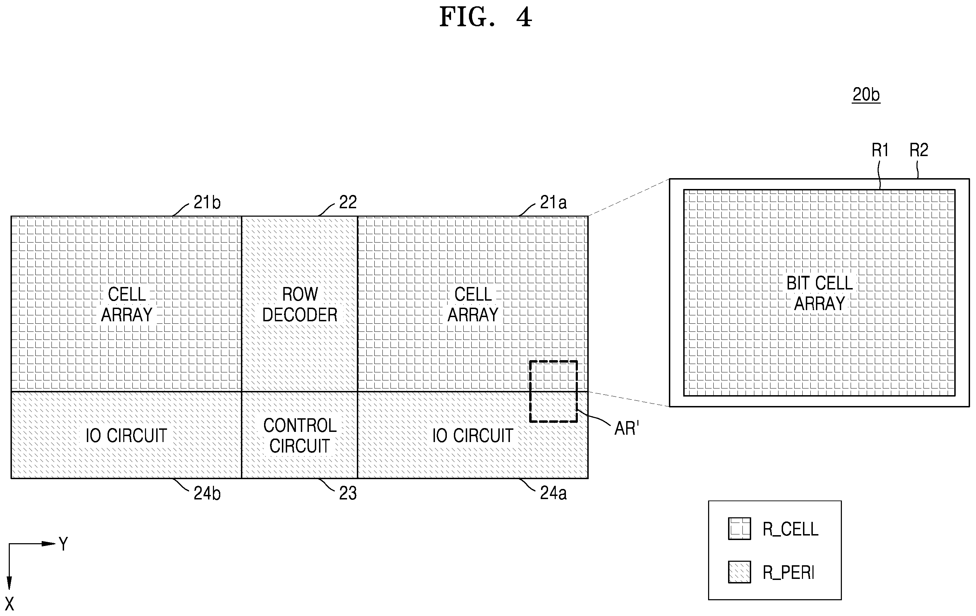

FIG. 4 is a plan view illustrating an integrated circuit 20b according to one or more example embodiments.

Referring to FIG. 4, the integrated circuit 20b may include at least one cell array arranged in the cell region R_CELL and a periphery circuit arranged in a peripheral region R_PERI. For example, the integrated circuit 20b may represent an example of the layout of an integrated circuit corresponding to the memory device 10 of FIG. 1. For example, a first cell array 21a and a second cell array 21b may be provided in the cell region R_CELL, and the row decoder 22, the control circuit 23, and a first I/O circuit 24a and a second I/O circuit 24b may be provided in the peripheral region R_PERI.

For example, the first cell array 21a may include a cell array region R1 and a transition region R2. A bit cell array including a plurality of bit cells may be arranged in the cell array region R1. The transition region R2 surrounds the cell array region R1 and may also be referred to as a dummy region, an outer region, or a termination region. The I/O circuit 24a may be provided adjacent to the first cell array 21a in the first direction X. The row decoder 22 may be provided between the first and second cell arrays 21a and 21b. Hereinafter, a partial region AR' of the first cell array 21a and the first I/O circuit 24a is described in detail with reference to FIGS. 5 to 14.

FIG. 5 illustrates a layout of an integrated circuit 30 according to a comparative example.

Referring to FIG. 5, the integrated circuit 30 may include active patterns RX each extending in the first direction X and gate lines GT each extending in the second direction Y. The bit cell array 31 may include gate lines G11 to G15, and a periphery circuit 33 may include gate lines G31 and G32. The transition region 32 may correspond to a region between the bit cell array 31 and the periphery circuit 33 and may include a termination gate line PB. A width of the termination gate line PB in the first direction X may be greater than a width of each of the gate lines G11 to G15, G31, and G32 in the first direction X.

Supporting patterns (e.g., dummy gate lines) may be arranged on opposite sides of the termination gate line PB. For example, the bit cell array 31 may include six supporting patterns (e.g., six dummy gate lines) arranged between the termination gate line PB and the gate line G15. For example, the periphery circuit 33 may include six supporting patterns (e.g., six dummy gate lines) arranged between the termination gate line PB and the gate line G31. Accordingly, the integrated circuit 30 may have a length X0 in the first direction X.

FIG. 6 illustrates a layout of the integrated circuit 40 according to one or more example embodiments.

Referring to FIG. 6, the integrated circuit 40 may include a bit cell array 41 and a periphery circuit 43, and the bit cell array 41 may be apart from the periphery circuit 43 in the first direction X. For example, the integrated circuit 40 may correspond to a partial area of the memory device 10 of FIG. 1. For example, the bit cell array 41 may correspond to a partial area of the bit cell array 11 of FIG. 1, and the periphery circuit 43 may correspond to a partial area of the I/O circuit 14 of FIG. 1. For example, the integrated circuit 40 may correspond to the partial area AR of FIG. 3 or the partial area AR' of FIG. 4.

The bit cell array 41 may include a plurality of bit cells including a first bit cell BC1 and a second bit cell BC2. The first and second bit cells BC1 and BC2 may be arranged adjacent to each other in the second direction Y. The first and second bit cells BC1 and BC2 may each have a first height Y1 in the second direction Y. The first height Y1 may be referred to as a "cell height". For example, the first and second bit cells BC1 and BC2 may correspond to the bit cells C11 and C12 of FIG. 2, respectively.

The periphery circuit 43 may include the standard cells including a first standard cell IO1, a second standard cell IO2, and a third standard cell IO3. The first to third standard cells IO1 to IO3 may be arranged adjacent to one another in the second direction Y. Each of the first to third standard cells IO1 to IO3 may have a second height Y2 in the second direction Y. Here, a number of transistors included in each of the first to third standard cells IO1 to IO3 may be less than a number of transistors included in each of the first and second bit cells BC1 and BC2, and thus, the second height Y2 may be less than the first height Y1. For example, a height (e.g., 2×Y1) of the first and second bit cells BC1 and BC2 may correspond to a height (e.g., 3×Y2) of the first to third standard cells IO1 to IO3. In an embodiment, the height (e.g., 2×Y1) of the first and second bit cells BC1 and BC2 may be equal to the height (e.g., 3×Y2) of the first to third standard cells IO1 to IO3. For example, the first to third standard cells IO1 to IO3 may correspond to I/O slices, respectively.

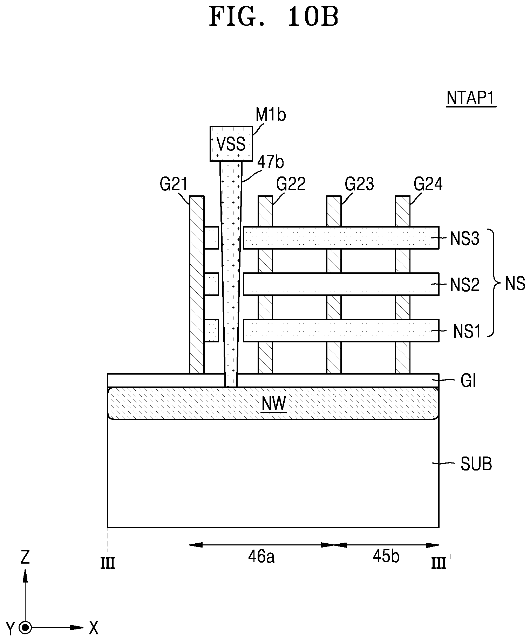

The integrated circuit 40 may further include a plurality of tap cells arranged in the transition region 42 between the bit cell array 41 and the periphery circuit 43. A tap cell may be a circuit (e.g. a passive circuit) configured to provide a voltage (e.g. a first power supply voltage or a second power supply voltage) to a well or substrate. A tap cell may ensure that the substrate or well are connected to the correct power supply voltage, preventing voltage drift and potential latch-up of the integrated circuit. The tap cells may be arranged in the second direction Y. For example, the tap cells may include P-type tap cells PTAP and N-type tap cells NTAP. The P-type tap cell PTAP may be configured to apply a first supply voltage (e.g., a power supply voltage) to a P-type well (e.g., PW in FIG. 10A) or a P-type substrate. The N-type tap cell NTAP may be configured to apply a second supply voltage (e.g., a ground voltage) to an N-type well (e.g., NW in FIG. 10B). For example, the transition region 42 may correspond to the dummy region or the transition region R2 of FIG. 3 or FIG. 4.

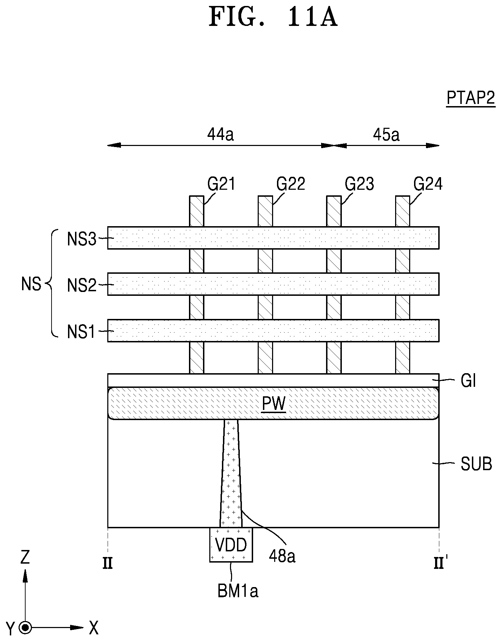

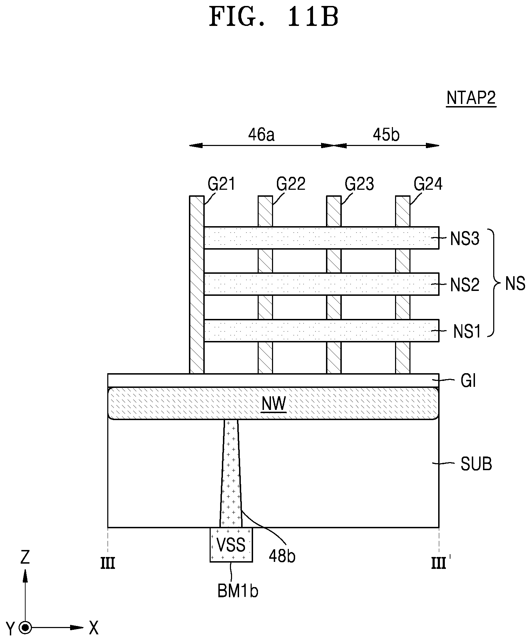

Each of the P-type tap cells PTAP and N-type tap cells NTAP may include a via VA. In an embodiment, the via VA may extend in a vertical direction Z on the substrate and connect to a front side wiring layer over an upper surface or front side of the substrate. Here, the via VA may receive the first supply voltage or the second supply voltage from the front side wiring layer and transmit the received first supply voltage or the second supply voltage to the P-type well or the N-type well. Details thereof will be described later with reference to FIGS. 10A and 10B. In an embodiment, the via VA may penetrate the substrate in the vertical direction Z and be connected to a backside wiring layer disposed on a lower surface or backside of the substrate. Here, the via VA may receive the first supply voltage or the second supply voltage from the backside wiring layer and transmit the received first supply voltage or second supply voltage to the P-type well or the N-type well. Details thereof will be described later with reference to FIGS. 11A and 11B.

In the integrated circuit 30 of FIG. 5, tap cells may be arranged in a region in which dummy gate lines are arranged in the bit cell array 31, and accordingly, the region in which the dummy gate lines are arranged may be used as a tap cell region. However, according to the present embodiment, a plurality of tap cells may be arranged in the second direction Y in the transition region 42, and accordingly, the bit cell array 41 does not need to have a tap cell region. Accordingly, a length of the bit cell array 41 in the first direction X may be reduced compared to the bit cell array 31 of FIG. 5. In this manner, according to the present embodiment, the area efficiency of the integrated circuit 40 may be improved by arranging the tap cells in the transition region 42.

FIGS. 7A and 7B illustrate devices according to one or more example embodiments. For example, FIG. 7A illustrates a gate-all-around field effect transistor (GAAFET) 50a including nanowires. For example, FIG. 7B illustrates a GAAFET including nanosheets, e.g., a multi-bridge channel field effect transistor (MBCFET) 50b. For convenience of illustration, FIGS. 7A and 7B illustrate that one of two source/drain regions is removed.

Referring to FIG. 7A, the GAAFET 50a may include active patterns, for example, nanowires, extending in the first direction X and apart from each other in the vertical direction Z and a gate line G extending in the second direction Y. For example, a nanowire may be a nanostructure having a height and width that is in the range of about 1-100 nm. The nanowires may each extend in the first direction X on an active region, which is defined by device isolation films, such as shallow trench isolation (STI). A source/drain S/D may be provided on opposite sides of the gate line G, and thus the source and the drain may be apart from each other in the first direction X. An insulating film, e.g., a gate insulating film, may be provided between a channel CH and the gate line G. It is noted that a number of nanowires included in GAAFET 50a is not limited to that shown in FIG. 7A. In addition, the width of each nanowire included in the GAAFET 50a may vary according to an embodiment.

Referring to FIG. 7B, the MBCFET 50b may include active patterns, e.g., nanosheets, extending in the first direction X and apart from each other in the vertical direction Z and the gate line G extending in the second direction Y. For example, a nanosheet may be a nanostructure having a height that is in the range of about 1-100 nm. The nanosheets may each extend in the first direction X on the active region, which is defined by device isolation films, such as STI. Nanosheets may have a relatively wide width in the second direction Y compared to nanowires. The source/drain S/D may be provided on opposite sides of the gate line G, and thus, the source and the drain may be apart from each other in the first direction X. An insulating film, e.g., a gate insulating film, may be provided between the channel CH and the gate line G. It is noted that a number of nanosheets included in the MBCFET 50b is not limited to that shown in FIG. 7B. In addition, the width of each of the nanosheets included in the MBCFET 50b may vary according to an embodiment.

The bit cells and the standard cells described herein may include GAA transistors, such as the GAAFET 50a of FIG. 7A and the MBCFET 50b of FIG. 7B. In an embodiment, the "active pattern" described herein may refer to nanowires or nanosheets. For example, each active pattern may include a plurality of nanowires apart from each other in the vertical direction Z. For example, each active pattern may include a plurality of nanosheets apart from each other in the vertical direction Z. However, the disclosure is not limited thereto, and the active pattern may be implemented according to various embodiments implementing the channel of the GAA transistor.

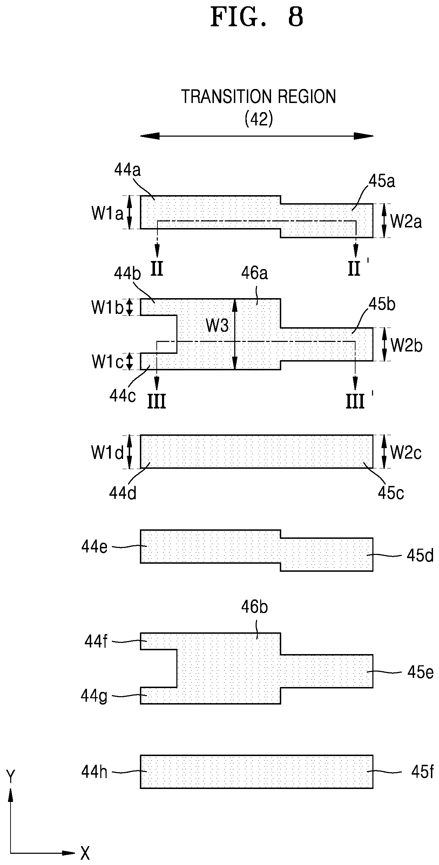

FIG. 8 illustrates active patterns arranged in the transition region 42 of FIG. 6 according to one or more example embodiments.

Referring to FIGS. 6 and 8 together, the integrated circuit 40 may include active patterns 44a to 44h, active patterns 45a to 45f, and merged patterns 46a and 46b. The active patterns 44a to 44h may be included in the bit cell array 41, and the active patterns 45a to 45f may be included in the periphery circuit 43. The merged patterns 46a and 46b may be provided in the transition region 42. The active patterns 44a to 44h of the bit cell array 41 may be connected to the active patterns 45a to 45f of the periphery circuit 43 in the transition region 42.

The active patterns 44a to 44h may each extend in the first direction X and be apart from each other in the second direction Y. For example, the active patterns 44a to 44d may be included in the first bit cell BC1, and thus may configure the GAA transistors included in the first bit cell BC1. For example, the active patterns 44e to 44h may be included in the second bit cell BC2, thereby configuring the GAA transistors included in the second bit cell BC2.

Each of the active patterns 44a and 44e may have a first width W1a in the second direction Y, each of the active patterns 44b and 44f may have a second width W1b in the second direction Y, each of the active patterns 44c and 44g may have a third width W1c in the second direction Y, and each of the active patterns 44d and 44h may have a fourth width W1d in the second direction Y. For example, the first width W1a and the fourth width W1d may be greater than the second width W1b and the third width W1c. For example, the first width W1a may be equal to the fourth width W1d, but the disclosure is not limited thereto. For example, the second width W1b may be equal to the third width W1c, but the disclosure is not limited thereto.

The active patterns 45a to 45f may each extend in the first direction X and be apart from each other in the second direction Y. For example, the active patterns 45a and 45b may be included in the first standard cell IO1, and thus, may configure the GAA transistors included in the first standard cell IO1. For example, the active patterns 45c and 45d may be included in the second standard cell IO2, and thus, may configure the GAA transistors included in the second standard cell IO2. For example, the active patterns 45e and 45f may be included in the third standard cell IO3, and thus, may configure the GAA transistors included in the third standard cell IO3.

The active patterns 45a and/or 45d may have a first width W2a in the second direction Y, the active patterns 45b and/or 45e may have a second width W2b in the second direction Y, and the active patterns 45c and/or 45f may have a third width W2c in the second direction Y. For example, the first to third widths W2a to W2c may be identical to each other, but the disclosure is not limited thereto. In some embodiments, the first width W1a of the active pattern 44a may be equal to the first width W2a of the active pattern 45a.

The active pattern 44a may be connected to the active pattern 45a in the transition region 42. For example, the active pattern 44a may not be aligned with the active pattern 45a, but the disclosure is not limited thereto. The active pattern 44d may be connected to the active pattern 45c in the transition region 42. For example, the active pattern 44d may be aligned with the active pattern 45c, but the disclosure is not limited thereto. Similarly, the active pattern 44e may be connected to the active pattern 45d in the transition region 42. For example, the active pattern 44e may not be aligned with the active pattern 45d, but the disclosure is not limited thereto. The active pattern 44h may be connected to the active pattern 45f in the transition region 42. For example, the active pattern 44h may be aligned with the active pattern 45f, but the disclosure is not limited thereto.

The active patterns 44b and 44c may be connected to the active pattern 45b via the merged pattern 46a. The merged pattern 46a may be provided in the transition region 42 and may have a width W3 in the second direction Y. For example, the width W3 may be greater than a sum of the second width W1b and the third width W1c. For example, the width W3 may be greater than the second width W2b. Similarly, the active patterns 44f and 44g may be connected to the active pattern 45e via the merged pattern 46b. The merged pattern 46b may be provided in the transition region 42 and may have a width W3 in the second direction Y. For example, the width W3 may be greater than the sum of the second width W1b and the third width W1c. For example, the width W3 may be greater than the second width W2b. In some embodiments, the second width W2b of the active pattern 45b may be greater than the second width W1b of the active pattern 44b and the third width W1c of the active pattern 44c.

Gate lines G21 to G24 may be arranged in the transition region 42. The gate lines G21 to G24 may each extend in the second direction Y and be apart from each other in the first direction X. Compared to the integrated circuit 30 of FIG. 5, instead of the termination gate line PB having a large width in the first direction X, the gate lines G21 to G24 may be arranged in the transition region 42. For example, the width of each of the gate lines G21 to G24 in the first direction X may be the same as the width of each of the gate lines G11 to G15, G31, and G32 in the first direction X.

The bit cell array 41 may include the active patterns 44a to 44h and the gate lines G11 to G15. The gate lines G11 to G15 may each extend in the second direction Y and be apart from each other in the first direction X. For example, the gate lines G11 and G12 may be arranged in a bit cell region BC and may form the first and second bit cells BC1 and BC2. For example, the gate lines G13 to G15 may be provided in a dummy bit cell region BC_D and may configure dummy bit cells but the disclosure is not limited thereto. In some embodiments, the gate lines G13 to G15 may be provided in the bit cell region BC and may configure real bit cells. Compared to the integrated circuit 30 of FIG. 5, dummy gate lines may not be provided between the gate lines G11 to G15 and the transition region 42. Accordingly, the length of the bit cell array 41 in the first direction X may be reduced compared to the bit cell array 31 of FIG. 5.

The periphery circuit 43 may include the active patterns 45a to 45f and the gate lines G31 and G32. The gate lines G31 and G32 may each extend in the second direction Y and be apart from each other in the first direction X. Compared to the integrated circuit 30 of FIG. 5, dummy gate lines may not be provided between the gate lines G31 and G32 and the transition region 42. Accordingly, a length of the periphery circuit 43 in the first direction X may be reduced compared to the periphery circuit 33 of FIG. 5.

As such, in contrast to FIG. 5, according to the present embodiment, the bit cell array 41 may not include supporting patterns (e.g., six dummy gate lines) arranged in a region adjacent to the transition region 42, and the periphery circuit 43 may not include supporting patterns (e.g., six dummy gate lines) arranged in a region adjacent to the transition region 42. In addition, according to the present embodiment, the area efficiency of the integrated circuit 40 may be improved by arranging a plurality of tap cells in the transition region 42, and the bit cell array 41 may not include a separate tap cell region. Accordingly, the integrated circuit 40 may have a first length X1 in the first direction X, and the first length X1 may be less than the length X0 of FIG. 5.

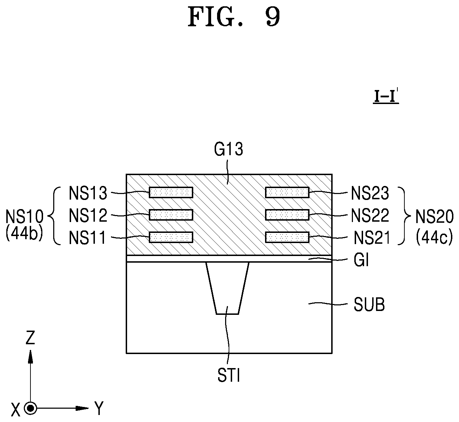

FIG. 9 is a cross-sectional view taken along line I-I' of FIG. 6 according to one or more example embodiments.

Referring to FIG. 9, an example of nanosheets being formed on an active region is illustrated. For example, an MBCFET may be formed in which a plurality of nanosheets are stacked on the active region and a gate line surrounds the nanosheets. However, the integrated circuit according to the disclosure is not limited to that illustrated in FIG. 9. For example, a GAAFET may be formed in which nanowires formed on the active region are surrounded by the gate lines.

The substrate SUB may include a semiconductor material, such as silicon, germanium, silicon-germanium, or a group III-V compound, such as GaAs, AlGaAs, InAs, InGaAs, InSb, GaSb, InGaSb, InP, GaP, InGaP, InN, GaN, InGaN, etc. For example, the substrate SUB may be a silicon-on-insulator (SOI) substrate or a germanium-on-insulator (GOI) substrate. For example, the substrate SUB may be doped with P-type impurities. The active regions may be defined by a device isolation film STI on the substrate SUB. For example, the active regions may include an N-type well doped with N-type impurities, and a P-type transistor, for example, a P-type GAA transistor, may be formed in the N-type well. For example, the active regions may include a P-type well doped with P-type impurities, and an N-type transistor, for example, an N-type GAA transistor, may be formed in the P-type well.

Active patterns, for example, nanosheets, may be provided on the active regions. A first nanosheet stack NS10 and a second nanosheet stack NS20 may function as channels of a transistor. For example, the first and second nanosheet stacks NS10 and NS20 may be doped with N-type impurities and form a P-type transistor, for example, a P-type GAA transistor. For example, the first nanosheet stack NS10 may correspond to the active pattern 44b and may include nanosheets NS11 to NS13 apart from each other in the vertical direction Z. For example, the second nanosheet stack NS20 may correspond to the active pattern 44c and may include nanosheets NS21 to NS23 apart from each other in the vertical direction Z.

The gate line G13 may surround each of the nanosheets NS11 to NS13 and NS21 to NS23, while covering the first nanosheet stack NS10 and the second nanosheet stack NS20. For instance, the gate line G13 may cover upper, lower and side surfaces (e.g. side surfaces in the second direction Y) of the nanosheets NS11 to NS13 and NS21 to NS23. The nanosheets NS11 to NS13 and NS21 to NS23 may have a GAA structure surrounded by the gate line G13. A gate insulating film (not shown) may be located between the first nanosheet stack NS10 and the second nanosheet stack NS20 and the gate line G13. In addition, a gate insulating film GI may be formed between the gate line G13 and the substrate SUB. The gate line G13 may be defined as a conductive segment including a conductive material, such as polysilicon or one or more metals.

FIG. 10A is a cross-sectional view taken along line II-II' of FIG. 6 according to one or more example embodiments, and FIG. 10B is a cross-sectional view taken along line III-III' of FIG. 6 according to one or more example embodiments. For example, FIG. 10A illustrates a P-type tap cell PTAP1, and FIG. 10B illustrates an N-type tap cell NTAP1.

Referring to FIG. 10A, an active region, for example, a P-type well PW, may be formed in the substrate SUB. The P-type tap cell PTAP1 may include a via 47a extending in the vertical direction Z on the substrate SUB. The via 47a may correspond to an example of the via VA of FIG. 6. The integrated circuit 40 may further include a first metal pattern M1a located above the upper surface or front side of the substrate SUB. For example, the via 47a may be connected to the first metal pattern M1a, and the first metal pattern M1a may receive a first supply voltage, for example, the power supply voltage VDD. Accordingly, the power supply voltage VDD applied to the first metal pattern M1a may be supplied to the P-type well PW through the via 47a. The via 47a may penetrate the nanosheet stack NS and the gate insulating film GI and may be insulated from the nanosheet stack NS.

The nanosheet stack NS may correspond to the active pattern 44a and the active pattern 45a of FIG. 8. In this manner, the active patterns 44a and 45a may be connected to each other in the transition region 42 to form the nanosheet stack NS. For example, the active pattern 44a may be doped with P-type impurities and form an N-type transistor, for example, an N-type GAA transistor. For example, the nanosheet stack NS may include Si, Ge, or SiGe. For example, the nanosheet stack NS may include InGaAs, InAs, GaSb, InSb, or any combination thereof. For example, the nanosheet stack NS may include three nanosheets NS1 to NS3. However, the disclosure is not limited thereto, and the number of nanosheets included in the nanosheet stack NS may vary according to an embodiment.

Referring to FIG. 10B, an active region, for example, the N-type well NW, may be formed in the substrate SUB. The N-type tap cell NTAP1 may include a via 47b extending in the vertical direction Z. The via 47b may correspond to an example of the via VA of FIG. 6. The integrated circuit 40 may further include a second metal pattern M1b located above the upper surface or front side of the substrate SUB. For example, the via 47b may be connected to the second metal pattern M1b, and the second metal pattern M1b may receive a second supply voltage, for example, the ground voltage VSS. Accordingly, the ground voltage VSS applied to the second metal pattern M1b may be supplied to the N-type well NW through the via 47b. The via 47b may penetrate the nanosheet stack NS and the gate insulating film GI and may be insulated from the nanosheet stack NS. The nanosheet stack NS may correspond to the merged pattern 46a and the active pattern 45b of FIG. 6. In this manner, the merged pattern 46a may be connected to the active pattern 45b in the transition region 42 to form the nanosheet stack NS.

FIG. 11A is a cross-sectional view taken along line II-II' of FIG. 6 according to one or more example embodiments, and FIG. 11B is a cross-sectional view taken along line III-III' of FIG. 6 according to one or more example embodiments. For example, FIG. 11A illustrates a P-type tap cell PTAP2, and FIG. 11B illustrates an N-type tap cell NTAP2. The P-type tap cell PTAP2 may correspond to a modified example of the P-type tap cell PTAP1 of FIG. 10A, the N-type tap cell NTAP2 may correspond to a modified example of the N-type tap cell NTAP2 of FIG. 10B, and the descriptions given above with reference to FIGS. 10A and 10B may be applied to the present embodiment.

Referring to FIG. 11A, the integrated circuit 40 may further include a first backside metal pattern BM1a located on the lower surface or backside of the substrate SUB. An active region, for example, the P-type well PW, may be formed in the substrate SUB. The P-type tap cell PTAP2 may include a backside via 48a extending in the vertical direction Z. The backside via 48a may correspond to an example of the via VA of FIG. 6. For example, the backside via 48a may penetrate the substrate SUB in the vertical direction Z and be connected to the first backside metal pattern BM1a. The first backside metal pattern BM1a may receive a first supply voltage, for example, the power supply voltage VDD. Accordingly, the power supply voltage VDD applied to the first backside metal pattern BM1a may be supplied to the P-type well PW through the backside via 48a.

Referring to FIG. 11B, the integrated circuit 40 may further include a second backside metal pattern BM1b disposed on the lower surface or backside of the substrate SUB. An active region, for example, an N-type well NW, may be formed in the substrate SUB. The N-type tap cell NTAP2 may include a backside via 48b extending in the vertical direction Z. The backside via 48b may correspond to an example of the via VA of FIG. 6. For example, the backside via 48b may penetrate the substrate SUB in the vertical direction Z and be connected to the second backside metal pattern BM1b. The second backside metal pattern BM1b may receive a second supply voltage, for example, the ground voltage VSS. Accordingly, the ground voltage VSS applied to the second backside metal pattern BM1b may be supplied to the N-type well NW through the backside via 48b.

As described above, the integrated circuit 40 may include a front side wiring layer disposed above the upper surface or front side of the substrate SUB and/or a backside wiring layer disposed on the lower surface or backside of the substrate SUB, and a power distribution network (PDN) may be implemented using the front side wiring layer and/or the backside wiring layer. Accordingly, some of signals and/or powers applied to the integrated circuit 40 may be transmitted through the front side wiring layer, e.g., a front side PDN (FSPDN), and the rest may be transmitted through the backside wiring layer, e.g., a back side PDN (BSPDN). Therefore, according to the present embodiment, a routing complexity may be significantly reduced and a length of each interconnection or each via may also be reduced, compared to a structure in which interconnections are arranged only on an upper side of the substrate, and thus, performance of the integrated circuit 40 may be improved.

FIG. 12 illustrates a layout of the integrated circuit 50 according to one or more example embodiments.

Referring to FIG. 12, the integrated circuit 50 may include a bit cell array 51, a transition region 52, and a periphery circuit 53. For example, the integrated circuit 50 may correspond to a partial area of the memory device 10 of FIG. 1. For example, the bit cell array 51 may correspond to a partial area of the bit cell array 11 of FIG. 1, and the periphery circuit 53 may correspond to a partial area of the I/O circuit 14 of FIG. 1. For example, the integrated circuit 50 may correspond to a partial area AR of FIG. 3 or a partial area AR' of FIG. 4. The integrated circuit 50 may correspond to a modified example of the integrated circuit 40 of FIG. 6, and the descriptions given above with reference to FIGS. 6 to 11B may be applied to the present embodiment.

The bit cell array 51 may include a bit cell region BC in which first and second bit cells BC1 and BC2 are arranged, a dummy bit cell region BC_D in which dummy bit cells are arranged, and a tap region TAP in which a plurality of tap cells are arranged, but the disclosure is not limited thereto. In some embodiments, the bit cell array 51 may not include the dummy bit cell region BC_D. A plurality of dummy gate lines GT each extending in the second direction Y and apart from each other in the first direction X may be arranged in the tap region TAP. In an embodiment, a plurality of tap cells may be arranged in the first direction X and/or the second direction Y in the tap region TAP. In an embodiment, the tap cells may be arranged in the first direction X and/or the second direction Y in the transition region 52 and the tap region TAP. Each of the tap cells may include a via and may transmit a first supply voltage or a second supply voltage to the active region, for example, the P-type well or the N-type well, through the via.

The periphery circuit 53 may include first to third standard cells IO1 to IO3. Gate lines G31 and G32 may extend in the second direction Y and be apart from each other in the first direction X and may form a GAA transistor included in the first to third standard cells IO1 to IO3. Here, dummy gate lines may not be provided between the transition region 52 and the gate lines G31 and G32. Accordingly, a length of the periphery circuit 53 in the first direction X may be reduced compared to the periphery circuit 33 of FIG. 5, and thus, a second length X2 of the integrated circuit 50 in the first direction X may be less than the length X0 of FIG. 5.

FIG. 13 illustrates a layout of the integrated circuit 60 according to one or more example embodiments.

Referring to FIG. 13, the integrated circuit 60 may include a bit cell array 61, a transition region 62, and a periphery circuit 63. For example, the integrated circuit 60 may correspond to a partial area of the memory device 10 of FIG. 1. For example, the bit cell array 61 may correspond to a partial area of the bit cell array 11 of FIG. 1, and the periphery circuit 63 may correspond to a partial area of the I/O circuit 14 of FIG. 1. For example, the integrated circuit 60 may correspond to a partial area AR of FIG. 3 or a partial area AR' of FIG. 4. The integrated circuit 60 may correspond to a modified example of the integrated circuit 40 of FIG. 6, and the descriptions given above with reference to FIGS. 6 to 11B may be applied to the present embodiment.

The bit cell array 61 may include a bit cell region BC in which first and second bit cells BC1 and BC2 are arranged and a dummy bit cell region BC_D in which dummy bit cells are arranged, but the disclosure is not limited thereto. In some embodiments, the bit cell array 61 may not include the dummy bit cell region BC_D. In the transition region 62, a plurality of tap cells may be arranged in the second direction Y. For example, the tap cells may include P-type tap cells PTAP and N-type tap cells NTAP. The periphery circuit 63 may include first to third standard cells IO1 to IO3. The gate lines G31 and G32 may extend in the second direction Y and be apart from each other in the first direction X and may form a GAA transistor included in the first to third standard cells IO1 to IO3. The periphery circuit 63 may further include a plurality of dummy gate lines GT arranged between the transition region 62 and the gate lines G31 and G32.

According to the present embodiment, the bit cell array 61 may not include dummy gate lines and/or a tap region. Thus, dummy gate lines may not be provided between the transition region 62 and the gate lines G11 to G15. Accordingly, a length of the bit cell array 61 in the first direction X may be reduced compared to the bit cell array 31 of FIG. 5, and thus, a third length X3 of the integrated circuit 60 in the first direction X may be less than the length X0 of FIG. 5.

FIG. 14 illustrates a layout of the integrated circuit 70 according to one or more example embodiments.

Referring to FIG. 14, the integrated circuit 70 may include a bit cell array 71 and a periphery circuit 73, and the bit cell array 71 may be apart from the periphery circuit 73 in the first direction X. For example, the integrated circuit 70 may correspond to a partial area of the memory device 10 of FIG. 1. For example, the bit cell array 71 may correspond to a partial area of the bit cell array 11 of FIG. 1, and the periphery circuit 73 may correspond to a partial area of the I/O circuit 14 of FIG. 1. For example, the integrated circuit 70 may correspond to a partial area AR of FIG. 3 or a partial area AR' of FIG. 4. The integrated circuit 70 may correspond to a modified example of the integrated circuit 40 of FIG. 6, and the descriptions given above with reference to FIGS. 6 to 11B may be applied to the present embodiment.

The bit cell array 71 may include a plurality of bit cells including first and second bit cells BC1 and BC2. The first and second bit cells BC1 and BC2 may be arranged adjacent to each other in the second direction Y. The first and second bit cells BC1 and BC2 may each have a first height Y1 in the second direction Y. For example, the first and second bit cells BC1 and BC2 may correspond to the bit cells C11 and C12 of FIG. 2, respectively.

The periphery circuit 73 may include first to fourth standard cells IO1' to IO4' including first to fourth standard cells. The first to fourth standard cells IO1' to IO4' may be arranged adjacent to one another in the second direction Y. Each of the first to fourth standard cells IO1' to IO4' may have a third height Y3 in the second direction Y. Here, a number of transistors included in each of the first to fourth standard cells IO1' to IO4' may be less than a number of transistors included in each of the first and second bit cells BC1 and BC2, and thus, the third height Y3 may be less than the first height Y1. For example, the height (e.g., 2×Y1) of the first and second bit cells BC1 and BC2 may correspond to (e.g. may be equal to) the height (e.g., 4×Y3) of the first to fourth standard cells IO1' to IO4'. For example, the first to fourth standard cells IO1' to IO4' may correspond to I/O slices, respectively.

The integrated circuit 70 may further include a plurality of tap cells arranged in a transition region 72 between the bit cell array 71 and the periphery circuit 73. The tap cells may be arranged in the second direction Y. For example, the tap cells may include P-type tap cells PTAP and N-type tap cells NTAP. The P-type tap cell PTAP may be configured to apply a first supply voltage (e.g., a power supply voltage) to a P-type well (e.g., PW in FIG. 10A) or a P-type substrate. The N-type tap cell NTAP may be configured to apply a second supply voltage (e.g., a ground voltage) to an N-type well (e.g., NW in FIG. 10B). For example, the transition region 72 may correspond to the dummy region or the transition region R2 of FIG. 3.

Each of the P-type tap cells PTAP and N-type tap cells NTAP may include a via VA. In an embodiment, the via VA may extend in the vertical direction Z across the substrate and be connected to a front side wiring layer disposed above the upper surface or front side of the substrate. Here, the via VA may receive the first supply voltage or the second supply voltage from the front side wiring layer and transmit the received first supply voltage or second supply voltage to the P-type well or the N-type well. For example, the P-type tap cells PTAP may be implemented as in FIG. 10A, and the N-type tap cells NTAP may be implemented as in FIG. 10B. In an embodiment, the via VA may penetrate the substrate in the vertical direction Z and be connected to a backside wiring layer disposed on the lower surface or backside of the substrate. Here, the via VA may receive a first supply voltage or a second supply voltage from the backside wiring layer and transmit the received first supply voltage or the second supply voltage to the P-type well or the N-type well. For example, P-type tap cells PTAP may be implemented as in FIG. 11A, and N-type tap cells NTAP may be implemented as in FIG. 11B.

According to the present embodiment, the tap cells may be arranged in the second direction Y in the transition region 72, and accordingly, the bit cell array 71 does not need to have a tap cell region. Accordingly, a length of the bit cell array 71 in the first direction X may be reduced compared to the bit cell array 31 of FIG. 5. In this manner, according to the present embodiment, the area efficiency of the integrated circuit 70 may be improved by arranging the tap cells in the transition region 72.

FIG. 15 illustrates active patterns arranged in the transition region 72 of FIG. 14 according to one or more example embodiments.

Referring to FIGS. 14 and 15 together, the integrated circuit 70 may include active patterns 74a to 74h and active patterns 75a to 75h. The active patterns 74a to 74h may be included in the bit cell array 71, and the active patterns 75a to 75h may be included in the periphery circuit 73. The active patterns 74a to 74h of the bit cell array 71 may be respectively connected to the active patterns 75a to 75h of the periphery circuit 73 in the transition region 72.

The active patterns 74a to 74h may each extend in the first direction X and be apart from each other in the second direction Y. For example, the active patterns 74a to 74d may be included in the first bit cell BC1, and thus may configure GAA transistors included in the first bit cell BC1. For example, the active patterns 74e to 74h may be included in the second bit cell BC2, and thus may configure GAA transistors included in the second bit cell BC2. For example, each of the active patterns 74a and 74d may have a first width W4a in the second direction Y, and each of the active patterns 74b and 74c may have a second width W4b in the second direction Y. For example, the first width W4a may be greater than the second width W4b. The active patterns 74e to 74h may be implemented with the same size as that of the active patterns 74a to 74d, respectively.

The active patterns 75a to 75h may each extend in the first direction X and be apart from each other in the second direction Y. For example, the active patterns 75a and 75b may be included in the first standard cell IO1', the active patterns 75c and 75d may be included in the second standard cell IO2', the active patterns 75e and 75f may be included in the third standard cell IO3', and the active patterns 75g and 75h may be included in the fourth standard cell IO4'. For example, each of the active patterns 75a, 75d, 75e, and 75h may have a first width W5a in the second direction Y, and each of the active patterns 75b, 75c, 75f, and 75g may have a second width W5b in the second direction Y. For example, the first width W5a may be greater than the second width W5b, but the disclosure is not limited thereto. In some embodiments, the first width W4a of the active pattern 74a may be different from the first width W5a of the active pattern 75a.

In the transition region 72, the gate lines G21 to G24 may be arranged. The gate lines G21 to G24 may each extend in the second direction Y and be apart from each other in the first direction X. Compared to the integrated circuit 30 of FIG. 5, instead of the termination gate line PB having a large width in the first direction X, gate lines G21 to G24 may be arranged in the transition region 72. For example, the width of each of the gate lines G21 to G24 in the first direction X may be the same as the width of each of gate lines G11 to G15, G31, and G32 in the first direction X.

The bit cell array 71 may include the active patterns 74a to 74h and the gate lines G11 to G15. The gate lines G11 to G15 may each extend in the second direction Y and be apart from each other in the first direction X. For example, the gate lines G11 and G12 may be arranged in the bit cell region BC and may form first and second bit cells BC1 and BC2. For example, the gate lines G13 to G15 may be provided in the dummy bit cell region BC_D and may configure dummy bit cells but the disclosure is not limited thereto. In some embodiments, the gate lines G13 to G15 may be provided in the bit cell region BC and may configure real bit cells. Compared to the integrated circuit 30 of FIG. 5, dummy gate lines may not be provided between the gate lines G11 to G15 and the transition region 72. Accordingly, the length of the bit cell array 71 in the first direction X may be reduced compared to the bit cell array 31 of FIG. 5.

The periphery circuit 73 may include the active patterns 75a to 75f and the gate lines G31 and G32. The gate lines G31 and G32 may each extend in the second direction Y and be apart from each other in the first direction X. Compared to the integrated circuit 30 of FIG. 5, dummy gate lines may not be provided between the gate lines G31 and G32 and the transition region 72. Accordingly, the length of the periphery circuit 73 in the first direction X may be reduced compared to the periphery circuit 33 of FIG. 5.

As such, according to the present embodiment, the bit cell array 71 may not include supporting patterns (e.g., six dummy gate lines) in a region adjacent to the transition region 72, and the periphery circuit 73 may not include supporting patterns (e.g., six dummy gate lines) in a region adjacent to the transition region 72. In addition, according to the present embodiment, the area efficiency of the integrated circuit 70 may be improved by arranging the tap cells in the transition region 72, and the bit cell array 71 may not include a separate tap cell region. Accordingly, the integrated circuit 70 may have a fourth length X4 in the first direction X, and the fourth length X4 may be less than the length X0 of FIG. 5.

FIG. 16 illustrates a layout of the integrated circuit 80 according to one or more example embodiments.

Referring to FIG. 16, the integrated circuit 80 may include a bit cell array 81 and a periphery circuit 83, and the bit cell array 81 may be apart from the periphery circuit 83 in the first direction X. For example, the integrated circuit 80 may correspond to a partial area of the memory device 10 of FIG. 1. For example, the bit cell array 81 may correspond to a partial area of the bit cell array 11 of FIG. 1, and the periphery circuit 83 may correspond to a partial area of the I/O circuit 14 of FIG. 1. For example, the integrated circuit 80 may correspond to a partial area AR of FIG. 3 or a partial area AR' of FIG. 4. The integrated circuit 80 may correspond to a modified example of the integrated circuit 70 of FIG. 14, and the descriptions given above with reference to FIGS. 6 to 15 may be applied to the present embodiment.

The bit cell array 81 may include a plurality of bit cells including first and second bit cells BC1 and BC2. The first and second bit cells BC1 and BC2 may be arranged adjacent to each other in the second direction Y. The first and second bit cells BC1 and BC2 may each have a first height Y1 in the second direction Y. For example, the first and second bit cells BC1 and BC2 may correspond to the bit cells C11 and C12 of FIG. 2, respectively.

The periphery circuit 83 may include first to fourth standard cells IO1" to IO4" including first to fourth standard cells. The first to fourth standard cells IO1" to IO4" may be arranged adjacent to one another in the second direction Y. Each of the first to fourth standard cells IO1" to IO4" may have a third height Y3 in the second direction Y. Here, a number of transistors included in each of the first to fourth standard cells IO1" to IO4" may be less than a number of transistors included in each of the first and second bit cells BC1 and BC2, and thus, the third height Y3 may be less than the first height Y1. For example, the height (e.g., 2×Y1) of the first and second bit cells BC1 and BC2 may correspond to (e.g. may be equal to) the height (e.g., 4×Y3) of the first to fourth standard cells IO1" to IO4". For example, the first to fourth standard cells IO1" to IO4" may correspond to I/O slices, respectively.

The integrated circuit 80 may further include a plurality of tap cells arranged in a transition region 82 between the bit cell array 81 and the periphery circuit 83. The tap cells may be arranged in the second direction Y. For example, the tap cells may include P-type tap cells PTAP and N-type tap cells NTAP. The P-type tap cell PTAP may be configured to apply a first supply voltage (e.g., a power supply voltage) to a P-type well (e.g., PW in FIG. 10A) or a P-type substrate. The N-type tap cell NTAP may be configured to apply a second supply voltage (e.g., a ground voltage) to an N-type well (e.g., NW in FIG. 10B). For example, the transition region 82 may correspond to the dummy region or the transition region R2 of FIG. 3.

Each of the P-type tap cells PTAP and N-type tap cells NTAP may include a via VA. In an embodiment, the via VA may extend in the vertical direction Z across the substrate and be connected to a front side wiring layer disposed above the upper surface or front side of the substrate. Here, the via VA may receive the first supply voltage or the second supply voltage from the front side wiring layer and transmit the received first supply voltage or second supply voltage to the P-type well or the N-type well. For example, the P-type tap cells PTAP may be implemented as in FIG. 10A, and the N-type tap cells NTAP may be implemented as in FIG. 10B. In an embodiment, the via VA may penetrate the substrate in the vertical direction Z and be connected to a backside wiring layer disposed on the lower surface or backside of the substrate. Here, the via VA may receive a first supply voltage or a second supply voltage from the backside wiring layer and transmit the received first supply voltage or the second supply voltage to the P-type well or the N-type well. For example, P-type tap cells PTAP may be implemented as in FIG. 11A, and N-type tap cells NTAP may be implemented as in FIG. 11B.

According to the present embodiment, the tap cells may be arranged in the second direction Y in the transition region 82, and accordingly, the bit cell array 81 does not need to have a tap cell region. Accordingly, a length of the bit cell array 81 in the first direction X may be reduced compared to the bit cell array 31 of FIG. 5. In this manner, according to the present embodiment, the area efficiency of the integrated circuit 80 may be improved by arranging the tap cells in the transition region 82.

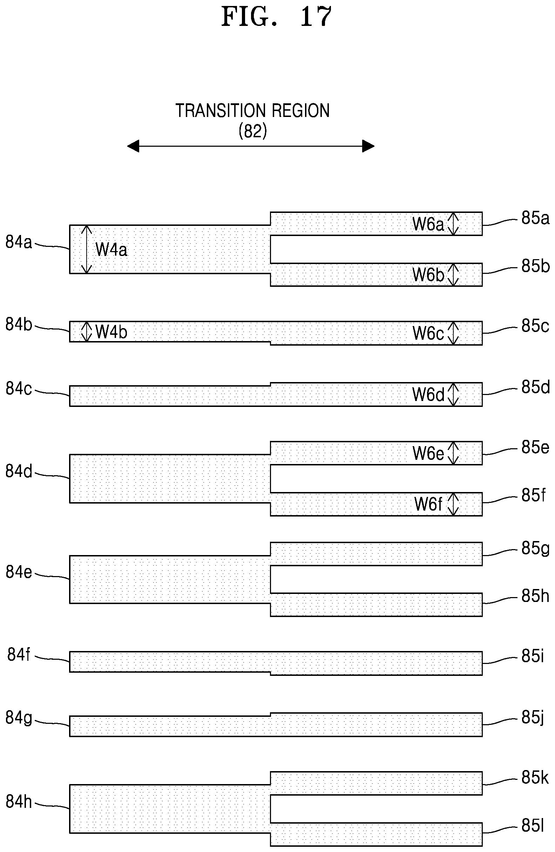

FIG. 17 illustrates active patterns arranged in the transition region 82 of FIG. 16 according to one or more example embodiments.

Referring to FIGS. 16 and 17 together, the integrated circuit 80 may include active patterns 84a to 84h and active patterns 85a to 85l. The active patterns 84a to 84h may be included in the bit cell array 81, and the active patterns 85a to 851 may be included in the periphery circuit 83. The active patterns 84a to 84h of the bit cell array 81 may be respectively connected to the active patterns 85a to 85l of the periphery circuit 83 in the transition region 82.

The active patterns 84a to 84h may each extend in the first direction X and be apart from each other in the second direction Y. For example, the active patterns 84a to 84d may be included in the first bit cell BC1, and thus may configure GAA transistors included in the first bit cell BC1. For example, the active patterns 84e to 84h may be included in the second bit cell BC2, and thus may configure GAA transistors included in the second bit cell BC2. For example, each of the active patterns 84a and 84d may have a first width W4a in the second direction Y, and each of the active patterns 84b and 84c may have a second width W4b in the second direction Y. For example, the first width W4a may be greater than the second width W4b. The active patterns 84e to 84h may be implemented with the same size as that of the active patterns 84a to 84d, respectively.

The active patterns 85a to 85l may each extend in the first direction X and be apart from each other in the second direction Y. For example, the active patterns 85a to 85c may be included in the first standard cell IO1", the active patterns 85d to 85f may be included in the second standard cell IO2", the active patterns 85g to 85i may be included in the third standard cell IO3", and the active patterns 85j to 85l may be included in the fourth standard cell IO4". The active pattern 85a may have a width W6a in the second direction Y, the active pattern 85b may be a width W6b in the second direction Y, the active pattern 85c may have a width W6c in the second direction Y, the active pattern 85d may have a width W6d in the second direction Y, the active pattern 85e may have a width W6e in the second direction Y, and the active pattern 85f may have a width W6f in the second direction Y. According to one example, the widths W6a to W6f may be the same, but the disclosure is not limited thereto. According to another example, at least one of the widths W6a to W6f may be different from the others.

According to one example, a space between the active patterns 85a and 85b may be the same as a space between the active patterns 85b and 85c, but the disclosure is not limited thereto. According to another example, the space between the active patterns 85a and 85b may be different from the space between the active patterns 85b and 85c. According to one example, spaces between adjacent active patterns among the active patterns 85a to 85l may be the same, but the disclosure is not limited thereto. According to another example, at least one of the spaces may be different from the others.

In the transition region 82, the gate lines G21 to G24 may be arranged. The gate lines G21 to G24 may each extend in the second direction Y and be apart from each other in the first direction X. Compared to the integrated circuit 30 of FIG. 5, instead of the termination gate line PB having a large width in the first direction X, gate lines G21 to G24 may be arranged in the transition region 82. For example, the width of each of the gate lines G21 to G24 in the first direction X may be the same as the width of each of gate lines G11 to G15, G31, and G32 in the first direction X.

The bit cell array 81 may include the active patterns 84a to 84h and the gate lines G11 to G15. The gate lines G11 to G15 may each extend in the second direction Y and be apart from each other in the first direction X. For example, the gate lines G11 and G12 may be arranged in the bit cell region BC and may form first and second bit cells BC1 and BC2. For example, the gate lines G13 to G15 may be provided in the dummy bit cell region BC_D and may configure dummy bit cells, but the disclosure is not limited thereto. In some embodiments, the gate lines G13 to G15 may be provided in the bit cell region BC and may configure real bit cells. Compared to the integrated circuit 30 of FIG. 5, dummy gate lines may not be provided between the gate lines G11 to G15 and the transition region 82. Accordingly, the length of the bit cell array 81 in the first direction X may be reduced compared to the bit cell array 31 of FIG. 5.

The periphery circuit 83 may include the active patterns 85a to 85l and the gate lines G31 and G32. The gate lines G31 and G32 may each extend in the second direction Y and be apart from each other in the first direction X. Compared to the integrated circuit 30 of FIG. 5, dummy gate lines may not be provided between the gate lines G31 and G32 and the transition region 82. Accordingly, the length of the periphery circuit 83 in the first direction X may be reduced compared to the periphery circuit 33 of FIG. 5.

As such, according to the present embodiment, the bit cell array 81 may not include dummy gate lines in a region adjacent to the transition region 82, and the periphery circuit 83 may not include dummy gate lines in a region adjacent to the transition region 82. In addition, according to the present embodiment, the area efficiency of the integrated circuit 80 may be improved by arranging the tap cells in the transition region 82, and the bit cell array 81 may not include a separate tap cell region. Accordingly, the integrated circuit 80 may have a fourth length X4 in the first direction X, and the fourth length X4 may be less than the length X0 of FIG. 5.

According to the present disclosure, the supporting patterns may be removed or omitted because the active patterns of the bit cell array are continuously connected to the active patterns of the periphery circuit across the transition region. This continuous connection prevents the active patterns from becoming isolated during the manufacturing process, thereby maintaining mechanical stability without the need for additional supporting patterns, such as dummy gate lines.

In a conventional structure, a discontinuity between the active patterns of the bit cell array and those of the periphery circuit would necessitate the provision of supporting patterns to prevent pattern collapse during processes such as etching or deposition. However, according to the present disclosure, since the active patterns of the bit cell array directly extend into and are connected with the active patterns of the periphery circuit, the structural integrity is inherently maintained. As a result, the supporting patterns can be significantly reduced or eliminated, thereby contributing to a reduction in the overall size of the device.

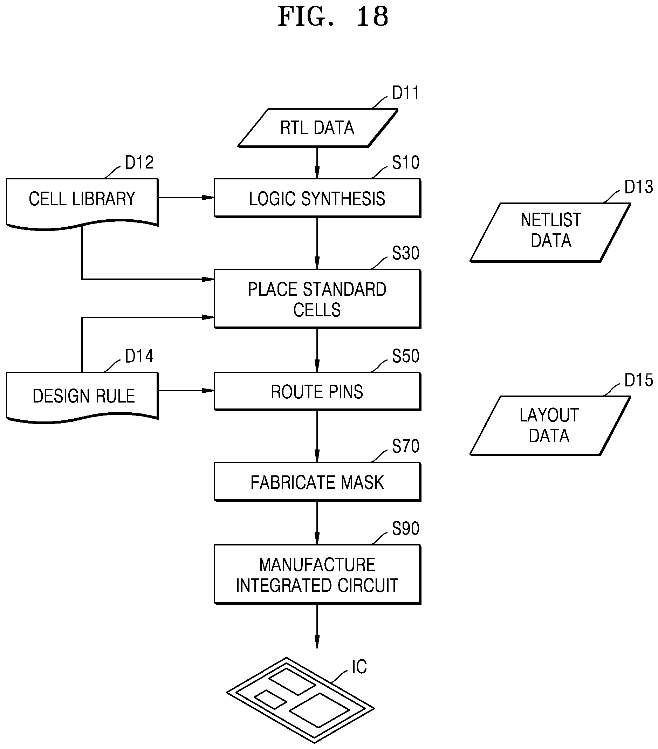

FIG. 18 is a flowchart illustrating a method for manufacturing an integrated circuit, according to one or more example embodiments.

Referring to FIG. 18, the method according to the present embodiment, as a method for manufacturing an integrated circuit IC including bit cells and standard cells, may include a plurality of operations S10, S30, S50, S70, and S90. A cell library (or a standard cell library) D12 may include information on standard cells, such as information on a function, a characteristic, a layout, etc. of a standard cell. In an embodiment, the cell library D12 may define a tap cell, a filler cell, and a dummy cell, as well as a functional cell configured to generates an output signal from an input signal. In an embodiment, the cell library D12 may define a plurality of bit cells. A design rule D14 may include one or more requirements that need to be satisfied by a layout of the integrated circuit IC. For example, the design rule D 14 may include requirements for spacing between patterns on the same layer, a minimum width of patterns, a routing direction in the wiring layer, etc.

In operation S10, a logic synthesis operation for generating netlist data D13 from register transfer level (RTL) data D11 may be performed. For example, a semiconductor design tool (e.g., a logic synthesis tool) may perform logic synthesis by referencing the cell library D12 using RTL data D11 written in a very high speed integrated circuit (VHSIC) hardware description language (VHDL) and hardware description language (HDL), such as Verilog, and may generate netlist data D13 including a bitstream or netlist. The netlist data D13 may correspond to an input to placement and routing operations described below.

In operation S30, standard cells may be placed using the cell library D12 and the design rule D14. For example, a semiconductor design tool (e.g., a place-and-route (P&R) tool) may place standard cells used in the netlist data D13 by referencing the cell library D12. In addition, the bit cells may be arranged. For example, a semiconductor design tool may place bit cells alongside the standard cells.

In operation S50, pins of the standard cells may be routed. For example, the semiconductor design tool may generate interconnections that electrically connect output pins to input pins of the placed standard cells and generate layout data D15 defining the placed standard cells and the generated interconnections. Interconnection may include via of a via layer and/or patterns of wiring layers. The wiring layers may include a front side wiring layer disposed above the upper surface or front side of the substrate and a backside wiring layer disposed on a lower surface or backside of the substrate. The layout data D15 may have a format, such as GDSII, and may include geometric information of cells and interconnections. The semiconductor design tool may refer to the design rule D14 while routing the pins of the standard cells. The layout data D15 may correspond to an output of placement and routing operations. Operation S50 alone or operations S30 and S50 collectively may be referred to as a method of designing an integrated circuit.

In an embodiment, as illustrated in FIGS. 1 to 15, an integrated circuit may include a bit cell array including a plurality of bit cells and a periphery circuit including the standard cells, the bit cell array may include a plurality of first active patterns each extending in the first direction, the periphery circuit may include a plurality of second active patterns each extending in the first direction, and the plurality of first active patterns may be connected to the plurality of second active patterns in a transition region between the bit cell array and the periphery circuit. For example, the periphery circuit may include an I/O circuit connected to the bit cell array via a plurality of bit lines. In an embodiment, the bit cell array may not include dummy gate lines in an outer region, e.g., a region adjacent to the transition region. In an embodiment, the I/O circuit may not include dummy gate lines in the outer region, e.g., the region adjacent to the transition region. Accordingly, the area of the integrated circuit may be reduced.

In an embodiment, a plurality of tap cells may be arranged in the second direction in the transition region. For example, the tap cells may include a P-type tap cell configured to apply a first supply voltage to a P-type well or a P-type substrate, and/or an N-type tap cell configured to apply a second supply voltage to an N-type well. In this manner, by utilizing the transition region between the bit cell array and the I/O circuit as a tap cell region, the area efficiency of the integrated circuit may be improved, thereby further reducing the area of the integrated circuit.

In operation S70, an operation of fabricating a mask may be performed. For example, optical proximity correction (OPC) to correct distortion phenomena, such as refraction caused by characteristics of light in photolithography may be applied to the layout data D15. Patterns on a mask may be defined to form patterns arranged in a plurality of layers based on data to which the OPC is applied, and at least one mask (or photomask) may be manufactured to form the patterns of each of the plurality of layers. In some embodiments, the layout of the integrated circuit IC may be limitedly modified in operation S70, and the limited modification of the integrated circuit IC in operation S70 may be referred to as design polishing as post-processing to optimize the structure of the integrated circuit IC.

In operation S90, an operation of manufacturing the integrated circuit IC may be performed. For example, the integrated circuit IC may be manufactured by patterning a plurality of layers using at least one mask manufactured in operation S70. A front-end-of-line (FEOL) may include, for example, operations of planarizing a wafer, cleaning the wafer, forming a trench, forming a well, forming a gate line, and forming a source and a drain. By means of the FEOL, individual components, such as transistors, capacitors, resistors, etc., may be formed on the substrate. In addition, a back-end-of-line (BEOL) may include, for example, operations of silicidating gate, source, and drain regions, adding a dielectric, planarizing, forming holes, adding a metal layer, forming a via, forming a passivation layer, etc. By the BEOL, individual components, such as transistors, capacitors, resistors, etc. may be interconnected. In some embodiments, a middle-of-line (MOL) may be performed between the FEOL and the BEOL, and contacts may be formed on individual elements. Next, the integrated circuit IC may be packaged into a semiconductor package and used as a component in a variety of applications.

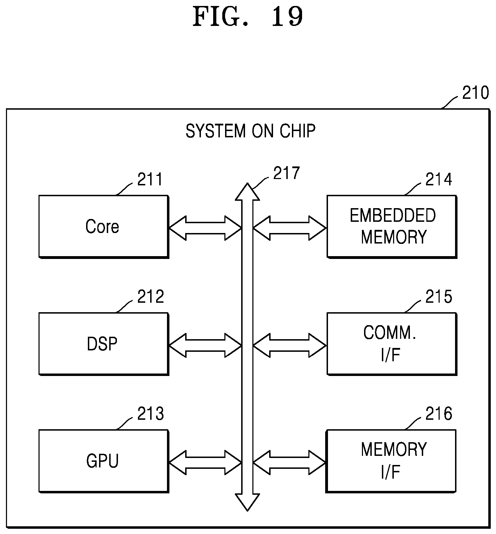

FIG. 19 is a block diagram illustrating a system-on-chip (SoC) 210 according to one or more example embodiments.

Referring to FIG. 19, the SoC 210 may refer to an integrated circuit that integrates components of a computing system or other electronic system. For example, as an example of the SoC 210, an application processor (AP) may include a processor and components for other functions. The SoC 210 may include a core 211, a digital signal processor (DSP) 212, a graphics processing unit (GPU) 213, a built-in memory (or an embedded memory) 214, a communication interface 215, and a memory interface 216. Components of the SoC 210 may communicate with each other through a bus 217.

The core 211 may process commands and control the operation of components included in the SoC 210. For example, the core 211 may drive an operating system and execute applications on the operating system by processing a series of commands. The DSP 212 may generate useful data by processing a digital signal, for example, a digital signal provided from the communication interface 215. The GPU 213 may generate data for an image output through a display device from image data provided from the built-in memory 214 and/or the memory interface 216 or may encode the image data. In some embodiments, the integrated circuit described above with reference to the drawings may be included in the core 211, the DSP 212, the GPU 213 and/or the built-in memory 214.

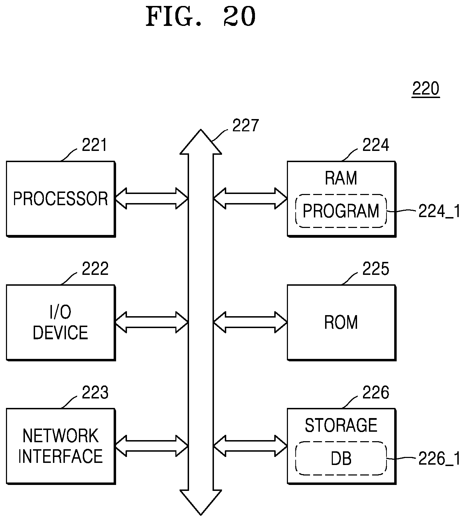

FIG. 20 is a block diagram illustrating a computing system 220 including a memory storing a program according to one or more example embodiments.

Referring to FIG. 20, a method of designing an integrated circuit according to embodiments, for example, at least some of the operations of the flowchart described above may be performed in the computing system (or a computer) 220. The computing system 220 may include at least one processor 221, I/O device 222, a network interface 223, a random access memory (RAM) 224, a read only memory (ROM) 225, and a storage (or a storage device) 226. The at least one processor 221, the I/O device 222, the network interface 223, the RAM 224, the ROM 225, and the storage 226 may be connected to a bus 227 and communicate with each other through the bus 227.

The at least one processor 221 may access a memory, e.g., RAM 224 or the ROM 225, through the bus 227 and execute instructions stored in the RAM 224 or the ROM 225. The RAM 224 may store a program 224_1 or at least a portion thereof for a method of designing an integrated circuit according to an embodiment, and the program 224_1 may cause the at least one processor 221 to perform at least some of the operations included in the method of designing an integrated circuit, for example, the method of FIG. 18. That is, the program 224_1 may include a plurality of instructions executable by the at least one processor 221, and the plurality of instructions included in the program 224_1 may cause the at least one processor 221 to perform at least some of the operations included in the flowcharts described above with reference to FIG. 18.

The storage 226 may store the program 224_1 according to an embodiment. In addition, the storage device 226 may store a database (DB) 226_1, and the database 226_1 may include information related to designing an integrated circuit, such as information on designed blocks, the cell library D12 of FIG. 18, and/or the design rule D14 in FIG. 18. The storage 226 may store data to be processed by the at least one processor 221 or data processed by the at least one processor 221. For example, the storage device 226 may store the RTL data D11, the netlist data D13 and/or the layout data D15 of FIG. 18.

At least one of the components, elements, modules or units (collectively "components" in this paragraph) represented by a block in the drawings, may be embodied as various numbers of hardware, software and/or firmware structures that execute respective functions described above, according to an example embodiment. For example, at least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. Two or more of these components may be combined into one single component which performs all operations or functions of the combined two or more components. Also, at least part of functions of at least one of these components may be performed by another of these components. Further, although a bus is not illustrated in the above block diagrams, communication between the components may be performed through the bus. Functional aspects of the above example embodiments may be implemented in algorithms that execute on one or more processors. Furthermore, the components represented by a block or processing steps may employ any number of related art techniques for electronics configuration, signal processing and/or control, data processing and the like.

While the disclosure has been particularly shown and described with reference to example embodiments thereof, it will be understood that various changes in form and details may be made therein without departing from the scope of the following claims and their equivalents.

## Claims

1. An integrated circuit comprising:
a bit cell array including a plurality of bit cells, each bit cell of the plurality of bit cells including a plurality of first active patterns and a first gate line surrounding the plurality of first active patterns; and
a periphery circuit apart from the bit cell array in a first direction, the periphery circuit including a plurality of second active patterns and a second gate line surrounding the plurality of second active patterns,
wherein each of the plurality of first active patterns and second active patterns extends in the first direction,
wherein each of the first gate line and the second gate line extends in a second direction intersecting the first direction, and
wherein the plurality of first active patterns are connected to the plurality of second active patterns in a transition region between the bit cell array and the periphery circuit.

2. The integrated circuit of claim 1, further comprising a plurality of tap cells in the transition region.

3. The integrated circuit of claim 2, wherein the plurality of tap cells are arranged in the second direction in the transition region.

4. The integrated circuit of claim 3, wherein the plurality of tap cells include at least one of a P-type tap cell configured to apply a first supply voltage to a P-type well or a P-type substrate and an N-type tap cell configured to apply a second supply voltage to an N-type well.

5. The integrated circuit of any preceding claim, wherein the bit cell array further includes a plurality of bit lines each extending in the first direction, and the periphery circuit further includes an input/output circuit connected to the bit cell array through the plurality of bit lines.

6. The integrated circuit of claim 4, wherein the bit cell array includes a first bit cell and a second bit cell arranged adjacent to each other in the second direction,
wherein the input/output circuit includes a first standard cell, a second standard cell, and a third standard cell arranged adjacent to each other in the second direction, and
wherein a sum of heights of the first bit cell and the second bit cell in the second direction corresponds to a sum of heights of the first to the third standard cells in the second direction.

7. The integrated circuit of any preceding claim, wherein a first active pattern among the plurality of first active patterns is connected to a second active pattern among the plurality of second active patterns, and
wherein the first active pattern is not aligned with the second active pattern.

8. The integrated circuit of claim 7, wherein the first active pattern has a first width in the second direction, and
wherein the second active pattern has a second width in the second direction, and
wherein the first width is different from the second width.

9. The integrated circuit of claim 7, wherein the first active pattern has a first width in the second direction,
wherein the second active pattern has a second width in the second direction, and
wherein the first width is equal to the second width.

10. The integrated circuit of any of claims 1-8, wherein the plurality of first active patterns include a first pattern and a second pattern apart from each other in the second direction, and
wherein the first pattern and the second pattern are connected to a third pattern through a merged pattern located in the transition region, the third pattern being one of the plurality of second active patterns.

11. The integrated circuit of claim 10, wherein the first pattern has a first width in the second direction,
wherein the second pattern has a second width in the second direction,
wherein the third pattern has a third width in the second direction, and
wherein the third width is greater than the first width and the second width.

12. The integrated circuit of claim 11, wherein the merged pattern has a fourth width in the second direction, and
wherein the fourth width is greater than a sum of the first width and the second width.

13. The integrated circuit of any of claims 1-6, wherein a first active pattern among the plurality of first active patterns is connected to a second active pattern among the plurality of second active patterns, and
wherein the first active pattern is aligned with the second active pattern.

14. The integrated circuit of claim 13, wherein the first active pattern has a first width in the second direction,
wherein the second active pattern has a second width in the second direction, and
wherein the first width is equal to the second width.

15. The integrated circuit of any preceding claim, wherein a number of the plurality of first active patterns is different from a number of the plurality of second active patterns.
